# EUROPÄISCHE PATENTSCHRIFT

(11) **EP 4 481 768 B1**
(45) Veröffentlichungstag und Bekanntmachung des Hinweises auf die Patenterteilung: **17.09.2025**
(21) Anmeldenummer: 24167488.6
(22) Anmeldetag: 28.03.2024
(51) Int. Cl.: G21K 1/00

(54) **VERFAHREN ZUR HERSTELLUNG EINER ELEKTRODENSTRUKTUR FÜR EINE IONENFALLE UND VERFAHREN ZUR HERSTELLUNG EINER ELEKTRODENANORDNUNG FÜR EINE 3-DIMENSIONALE IONENFALLE**
METHOD FOR MANUFACTURING ELECTRODE STRUCTURE FOR ION TRAP AND METHOD FOR MANUFACTURING ELECTRODE ASSEMBLY FOR 3-DIMENSIONAL ION TRAP
PROCÉDÉ DE FABRICATION D'UNE STRUCTURE D'ÉLECTRODE POUR PIÈGE À IONS ET PROCÉDÉ DE FABRICATION D'UN ENSEMBLE ÉLECTRODE POUR PIÈGE À IONS TRIDIMENSIONNEL

(30) Priorität: 23.06.2023 DE 102023205968; 31.01.2024 EP 24155147
(43) Veröffentlichungstag der Anmeldung: 25.12.2024
(73) Patentinhaber: Fraunhofer-Gesellschaft zur Förderung der angewandten Forschung e.V., 80686 München (DE)
(72) Erfinder: KUTTER, Christoph, 80686 München (DE); RAMM, Peter, 80686 München (DE); BADAWI, Bassem, 80686 München (DE)
(74) Vertreter: Hersina, Günter

(56) Entgegenhaltungen:
- DE-A1- 102019 205 183
- KR-A- 20160 053 115
- KR-A- 20190 048 956
- US-A1- 2014 240 944
- CHO DONG-IL "DAN" ET AL: "A review of silicon microfabricated ion traps for quantum information processing", vol. 3, no. 1, 23 April 2015 (2015-04-23), XP055782266, Retrieved from the Internet <URL:http://link.springer.com/article/10.1186/s40486-015-0013-3/fulltext.html> DOI: 10.1186/s40486-015-0013-3

## Beschreibung

### Technisches Gebiet

Die vorliegende Erfindung bezieht sich auf Verfahren zur Herstellung einer Elektrodenstruktur für eine Ionenfalle, insbesondere ein Verbinden eines Basis-Substrats mit einem Isolationssubstrat. Die vorliegende Erfindung bezieht sich auf ein Verfahren zur Herstellung einer Elektrodenanordnung für eine 3-dimensionale Ionenfalle.

Beispielsweise wird ein Verfahren zur Herstellung von Oberflächenionenfallen mittels Einfach- und/oder Multilagenmetallisierung auf Glass-, Quarz, Korund, Diamant- oder Keramiksubstrat sowie ein Aufbau einer 3-dimensionalen lonenfallen-Anordnung durch Oberflächenionenfallen vorgestellt.

### Technischer Hintergrund

Quantencomputer sind Prozessoren, welche quantenmechanische Zustände von Systemen, wie beispielsweise von Qubits, nutzen. Ein Ansatz für die Realisierung von Qubits in Quantencomputer ist die Verwendung von Ionen in lonenfallen. Hierbei werden beispielsweise einzelne Ionen durch elektromagnetische Felder im Vakuum in einer Reihe aufgereiht.

Moderne Ionenfallen, wie sie für Quantencomputer verwendet werden, umfassen beispielsweise Oberflächenelektroden und werden durch einen multilagen Metallaufbau angesteuert. Derartige Strukturen werden bevorzugt in standardisierten Prozessabläufen aus der Siliziumhalbleiterfertigung hergestellt, da diese besonders steuerbar und skalierbar sind. In Verbindung mit weiteren metallischen Strukturen, wie beispielsweise eine elektrisch leitende Schirmung innerhalb eines Siliziumsubstrats, können dadurch große parasitäre Kapazitäten entstehen, die die Kohärenzzeit der Ionenzustände verkürzen können. Ein Überblick über Silizium-Ionenfallen für Quantencomputer kann in Cho Dong-II "Dan" et al: "A review of silicon microfabricated ion traps for quantum information processing",Micro and Nano Systems Letters, Bd. 3, Nr. 1, 23.04.2015, gefunden werden. Weitere Ionenfallen, die für Quantumcomputer verwendet werden, sind aus KR 10-2016-0053115 A, KR 10-2019-0048956 A und DE 10 2019 205 183 A1 bekannt. Ferner, offenbart US 2014/240944 A1 eine mikroelektronische Schaltung mit einem Bauteil neben einem Träger, der kein Halbleiter oder Saphir ist.

Die der vorliegenden Erfindung zugrundeliegende Aufgabe besteht daher darin, ein verbessertes Verfahren zur Herstellung einer Elektrodenstruktur für eine Ionenfalle bereitzustellen, und ferner ein verbessertes Verfahren zur Herstellung einer Elektrodenanordnung für eine 3-dimensionale Ionenfalle bereitzustellen, wodurch lonenfallen mit verbesserten Eigenschaften geschaffen werden.

Diese Aufgabe wird durch den Gegenstand der unabhängigen Patentansprüche gelöst.

Spezifische Ausgestaltungen, Implementierungen und Weiterbildungen der vorliegenden Anmeldung sind in den abhängigen Patentansprüchen definiert.

### Überblick über das erfindungsgemäße Konzept

Die vorliegende Erfindung basiert auf der Erkenntnis, dass mit den gezeigten Herstellungsverfahren eine Elektrodenstruktur hergestellt werden kann, die ein Basis-Substrat mit einer Halbleiterschicht verwendet, das der Herstellung durch Standard-Halbleiterfertigungsprozessschritte zugänglich ist, und dass das Basis-Substrat im Rahmen der Herstellung einer Rückdünnung ausgesetzt werden kann, welche diese Halbleiterschicht (teilweise oder vollständig) entfernen kann. Dadurch können Probleme, die von Halbleitermaterialien wie Silizium verursacht werden (z. B. hohe parasitäre Kapazitäten), reduziert oder vermieden werden. Gerade bei der Anwendung für Ionenfallen können dadurch Kohärenzzeiten von Qubits verbessert werden. Es wurde erkannt, dass ein Verbinden mit einem Isolationssubstrat, das ein dielektrisches Material aufweist, einen Träger bereitgestellt wird, der dem Isolationsmaterial mit der strukturierten Metallisierungsanordnung eine mechanische Stabilität zum Verarbeiten (z. B. beim Rückdünnen und Verbinden mit anderen Komponenten) bereitstellt, aber die oben in Verbindung mit der Halbleiterschicht beschriebenen Nachteile nicht oder in einem geringeren Ausmaß aufweist.

Da das Basis-Substrat mittels Standard-Halbleiterfertigungsprozessschritte hergestellt werden kann, können auch die Metallisierungsanordnung mittels Standard-Halbleiterfertigungsprozessschritte hergestellt werden. Daher kann die Metallisierungsanordnung und die daraus entstehenden Elektrodenstruktur mit hoher Präzision und in skalierbaren Menge hergestellt werden. Ein mittels Standard-Halbleiterfertigungsprozessschritte hergestelltes Basis-Substrat weist Strukturen auf, welche üblicherweise gleichmäßiges Verhalten bei einem Rückdünnen aufweisen, so das eine (z. B. flache) Form einer Oberfläche des rückgedünnten Basis-Substrats sowie die darauf aufgebrachte strukturierte Oberflächenmetallisierung mit einer hohen Präzision gesteuert werden kann.

Es wurde erkannt, dass die Vorteile der Elektrodenstrukturen auch genutzt werden können bei einer Verbindung von Elektrodenstrukturen zu einer Elektrodenanordnung. Die Kombination von gegenüberliegenden Elektrodenstrukturen erhöht eine Flexibilität in einer Feldverteilung, so dass Positionen von Ionen einem drei-dimensionalen Raum besser gesteuert werden können. So kann beispielsweise eine 3-dimensionale Ionenfalle, z.B. eine Paullonenfallen-Anordnung, durch zwei oder mehrere Elektrodenstrukturen (oder Oberflächenfallen, die derartige Elektrodenstrukturen aufweisen) realisiert werden. Die Anordnung der Elektrodenstrukturen und der davon erzeugten elektrischen Felder kann bei die Herstellung der Elektrodenstrukturen und durch die Abstandshalterstruktur gesteuert werden.

Somit kann erreicht werden, dass eine Elektrodenstruktur und eine Elektrodenanordnung hergestellt werden, die zwar Standard-Halbleiterfertigungsprozessschritte zugänglich sind, aber von Materialien aus der Halbleiterfertigung erzeugte Probleme reduziert.

### Kurzbeschreibung der Zeichnungen und Figuren

Bevorzugte Ausführungsbeispiele der vorliegenden Erfindung werden nachfolgend unter Bezugnahme auf den beiliegenden Zeichnungen und Figuren näher erläutert. Es zeigen:
- Fig. 1: ein schematisches Flussdiagramm des erfindungsgemäßen Herstellungsverfahrens gemäß einem Ausführungsbeispiel;
- Fig. 2a: zeigt einen schematischen Querschnitt eines Beispiels für ein Basis-Substrat mit einer Halbleiterschicht und einer in einem Isolationsmaterial angeordneten strukturierten Metallisierungsanordnung;
- Fig. 2b: zeigt einen schematischen Querschnitt eines Beispiels eines Basis-Substrats mit Metallanschlussflächen;
- Fig. 3a: zeigt einen schematischen Querschnitt eines Beispiels eines Isolationssubstrats mit einem dielektrischen Material;
- Fig. 3b: zeigt einen schematischen Querschnitt eines Beispiels eines Isolationssubstrats mit einer Metallanschlussfläche;
- Fig. 3c: zeigt einen schematischen Querschnitt eines Beispiels eines Isolationssubstrats mit mehreren Metallanschlussflächen;
- Fig. 4a: zeigt einen schematischen Querschnitt einer getrennten Anordnung des Basis-Substrats und des Isolationssubstrats;
- Fig. 4b: zeigt einen schematischen Querschnitt eines Anordnens des Basis-Substrats auf dem Isolationssubstrat;
- Fig. 4c: zeigt einen schematischen Querschnitt eines Verbunds des Basis-Substrats mit dem Isolationssubstrat;
- Fig. 5a: zeigt einen schematischen Querschnitt eines Beispiels eines Verbunds des Basis-Substrats mit dem Isolationssubstrat mittels eines Metall-Bondvorgangs;
- Fig. 5b: zeigt einen schematischen Querschnitt eines Beispiels eines Verbunds des Basis-Substrats mit dem Isolationssubstrat mittels eines Metall-Bondvorgangs;
- Fig. 6a: zeigt einen schematischen Querschnitt eines Beispiels, in dem die Elektrodenstruktur für die Ionenfalle gebildet wird, indem der Schritt des Rückdünnes bis zu der Metallisierungsanordnung durchgeführt wird;
- Fig. 6b: zeigt einen schematischen Querschnitt eines Beispiels, in dem die Elektrodenstruktur für die Ionenfalle gebildet wird, indem eine strukturierte Oberflächenmetallisierung auf das Isolationsmaterial des rückgedünnten Basis-Substrats aufgebracht wird;
- Fig. 7a: zeigt einen schematischen Querschnitt eines Beispiels für ein Basis-Substrat vor einem Ausbilden einer Ausnehmung;
- Fig. 7b: zeigt einen schematischen Querschnitt des Basis-Substrats aus Fig. 7a nach einem Ausbilden einer Ausnehmung;
- Fig. 7c: zeigt einen schematischen Querschnitt eines Verbunds nach einem Verbinden des Basis-Substrats aus Fig. 7b mit einem Isolationssubstrat;
- Fig. 8a: zeigt einen schematischen Querschnitt einer Elektrodenvorrichtung mit dem Verbund aus Fig. 7c nach einem Rückdünnen des Basis-Substrats;
- Fig. 8b: zeigt einen schematischen Querschnitt der Elektrodenvorrichtung aus Fig. 8a nach einem Anordnen einer Metallisierung;
- Fig. 9a: zeigt ein schematisches Flussdiagramm eines erfindungsgemäßen Herstellungsverfahrens gemäß einem Ausführungsbeispiel;
- Fig. 9b: zeigt einen schematischen Querschnitt eines Beispiels eines Elektrodensystems mit einer Elektrodenanordnung für eine 3-dimensionale Ionenfalle;
- Fig. 10a: zeigt einen schematischen Querschnitt eines weiteren Beispiels eines Elektroden-systems mit einer Elektrodenanordnung für eine 3-dimensionale Ionenfalle;
- Fig. 11a: zeigt einen schematischen Querschnitt eines weiteren Beispiels eines Elektrodensystems für eine 3-dimensionale Ionenfalle;
- Fig. 11b: zeigt einen schematischen Querschnitt eines weiteren Beispiels eines Elektrodensystems für eine 3-dimensionale Ionenfalle mit einer Metallisierungsfläche auf nicht-metallischen Seitenwandbereichen; und
- Fig. 12: zeigt eine schematische Aufsicht auf ein Beispiel einer Ionenfalle mit einer Elektrodenvorrichtung.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte (mit gleichen Bezugszeichen) untereinander austauschbar ist bzw. aufeinander angewendet werden kann.

### Detaillierte Beschreibung der Figuren und Ausführungsbeispiele

In der nachfolgenden Beschreibung bedeutet die Beschreibung einer Halbleiterschicht, dass die Halbleiterschicht ein Halbleitermaterial aufweist, d.h. zumindest teilweise oder auch vollständig aus dem Halbleitermaterial gebildet ist. In der nachfolgenden Beschreibung bedeutet die Beschreibung eines Isolationssubstrats, dass das Substrat ein elektrisch isolierendes Material aufweist, d.h. zumindest teilweise oder auch vollständig aus dem elektrisch isolierenden Material gebildet ist.

Es versteht sich, dass, wenn ein Element als mit einem anderen Element "verbunden" oder "gekoppelt" bezeichnet wird, es direkt mit dem anderen Element verbunden oder gekoppelt sein kann oder Zwischenelemente vorhanden sein können. Wenn im Gegensatz ein Element als "direkt" mit einem anderen Element "verbunden" oder "gekoppelt" bezeichnet wird, sind keine Zwischenelemente vorhanden. Sonstige zum Beschreiben des Verhältnisses zwischen Elementen benutzten Ausdrücke sollten auf gleichartige Weise ausgelegt werden (z.B. "zwischen" gegenüber "direkt zwischen", "benachbart" gegenüber "direkt benachbart" usw.).

Zur Vereinfachung der Beschreibung der unterschiedlichen Ausführungsbeispiele weisen zumindest einige der Figuren ein kartesisches Koordinatensystem x, y, z auf, wobei die Richtungen x, y, z orthogonal zueinander angeordnet sind. Bei den Ausführungsbeispielen entspricht die x-y-Ebene dem Hauptoberflächenbereich eines Trägers bzw. Substrats (= Referenzebene = x-y-Ebene), wobei die dazu vertikale Richtung nach oben bezüglich der Referenzebene (x-y-Ebene) der "+z"-Richtung entspricht, und wobei die Richtung vertikal nach unten bezüglich der Referenzebene (x-y-Ebene) der "-z"-Richtung entspricht. In der folgenden Beschreibung bedeutet der Ausdruck "lateral" eine Richtung parallel zu der x-und/oder y-Richtung, d. h. parallel zu der x-y-Ebene, wobei der Ausdruck "vertikal" eine Richtung parallel zu der +/- z-Richtung angibt.

Im Rahmen der vorliegenden Beschreibung sind in Klammern gesetzte Begriffe und/oder Textpassagen beispielhaft als weitere Erläuterungen, beispielhafte Ausgestaltungen, Ergänzungen und/oder beispielhafte Alternativen (zu dem voranstehenden Begriff oder der voranstehenden Textpassage) zu verstehen.

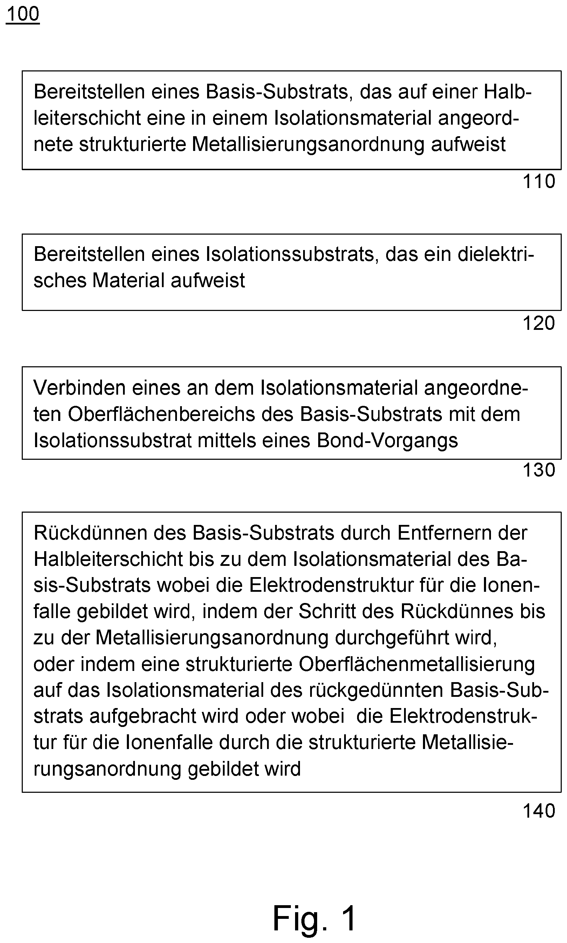

Fig. 1 zeigt ein schematisches Flussdiagramm 100 des erfindungsgemäßen Herstellungsverfahrens gemäß einem Ausführungsbeispiel. Das Verfahren wird genutzt zur Herstellung einer Elektrodenstruktur für eine Ionenfalle.

Das Verfahren umfasst in einem Schritt 110 ein Bereitstellen eines Basis-Substrats, das auf einer Halbleiterschicht eine in einem Isolationsmaterial angeordnete strukturierte Metallisierungsanordnung aufweist.

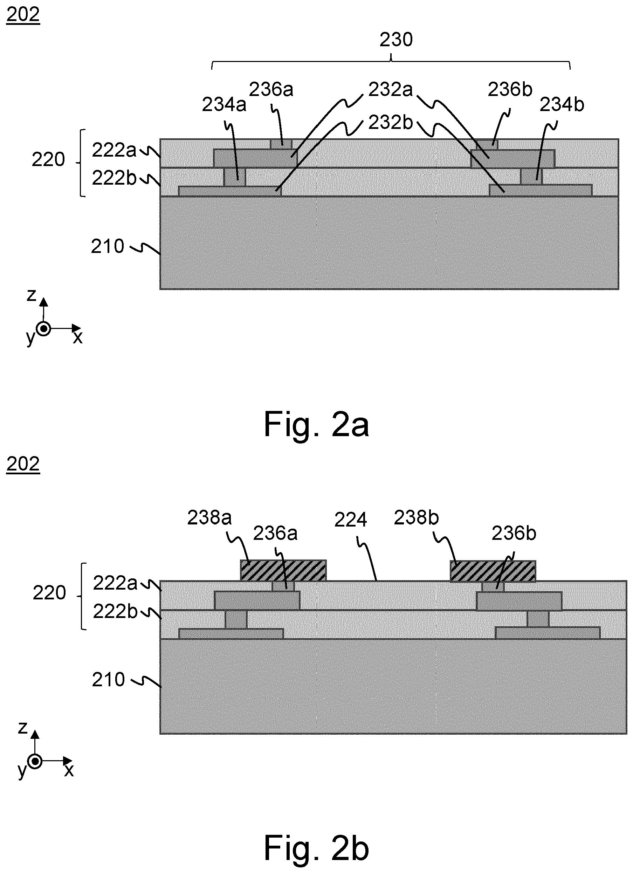

Fig. 2a zeigt einen schematischen Querschnitt eines Beispiels für ein Basis-Substrat 202 mit einer Halbleiterschicht 210 und einer in einem Isolationsmaterial 220 angeordneten strukturierten Metallisierungsanordnung 230.

Das Basis-Substrat 202 kann als ein Standard-Substrat aus der Halbleiterfertigung oder als ein Integrated-Circuit-(IC)-Substrat (Substrat für einen integrierten Schaltkreis) ausgebildet sein. Das Basis-Substrat 202 (z. B. deren Halbleiterschicht 210) kann zumindest eines umfassen aus Silizium, Germanium und Galliumarsenid. Das Basis-Substrat kann ein Wafer, mehrere Wafer oder ein Ausschnitt aus einem Wafer sein (z. B. eines einkristallinen Halbleitermaterials). Ein Standard-Substrat aus der Halbleiterfertigung oder ein IC-Substrat kann mit hoher Präzision und Skalierbarkeit hergestellt werden oder ist leichter verfügbar. Ferner kann die Herstellung der Elektrodenstruktur optional mit einem Herstellungsprozess für das Standard-Substrat kombiniert werden.

Das Isolationsmaterial 220 des Basis-Substrats 202 kann ein Dielektrikum aus der Halbleiterfertigung, wie z.B. SiO₂, HfO₂, oder GeO₂ aufweisen. Das Basis-Substrat 202 kann optional weitere Komponenten (z. B. Schichten) aufweisen, wie beispielsweise zumindest eines aus einer Oxidschicht (z. B. auf einer dem Isolationsmaterial 220 zugewandten und/oder abgewandten Oberfläche der Halbleiterschicht 210) und einem Material zur Befestigung einer dem Isolationsmaterial 220 abgewandten Oberfläche der Halbleiterschicht 210 an einem Trägersubstrat.

Dielektrika aus der Halbleiterfertigung ermöglichen die Herstellung des Isolationsmaterials 220 in Standard-Halbleiterfertigungsprozessschritten. Somit kann die Metallisierungsanordnung 230 über eine Strukturierung des Isolationsmaterials 220 mittels Standard-Halbleiterfertigungsprozessschritten erfolgen, so dass die Metallisierungsanordnung 230 und die Elektrodenstruktur präzise und skalierbar geformt werden können.

In der nachfolgenden Beschreibung werden Ausführungsbeispiele beschrieben, in denen die Halbleiterschicht 210 Silizium umfasst und das Isolationsmaterial 220 Siliziumoxid umfasst. Die Offenbarung ist jedoch nicht auf diese (oder sonstige nachfolgend beschriebene) Materialbeispiele beschränkt.

Die Metallisierungsanordnung 230 kann als eine Mehrlagenmetallisierungsanordnung ausgebildet sein. Die Metallisierungsanordnung 230 kann folglich komplexere Strukturen aufweisen, so dass eine Führung von elektrischen Leitungen innerhalb des Isolationsmaterial 220 erleichtert wird und Elektrodenstrukturen besser an Anforderungen für elektrischen Felder angepasst werden können.

Fig. 2a zeigt ein Beispiel einer Mehrlagenmetallisierungsanordnung 230, die zwei Metallisierungsschichten 232a, b aufweist. Die Metallisierungsanordnung 230 weist erste Durchkontaktierungen 234a, b auf, die jeweils zwei Metallisierungsschichten 232a, b elektrisch miteinander verbinden. Die Metallisierungsanordnung 230 kann weitere erste Durchkontaktierungen 234a, b für weitere Metallisierungsschichten 232a, b aufweisen. Die Metallisierungsanordnung 230 weist zweite Durchkontaktierungen 236a, b auf, welche sich von einer (z. B. obersten) Metallisierungsschicht 232a zu einer Oberfläche des Isolationsmaterial 220 erstrecken. Das Rückdünnen bis zur obersten Metallisierungsschicht 232a ermöglicht die Elektrodenstruktur vollständig (oder nahezu vollständig) innerhalb des Isolationsmaterials 220 zu formen. Daher ist diese Elektrodenstruktur 230 einer Formung mittels Standard-Halbleiterfertigungsprozessschritten zugänglich.

Das Isolationsmaterial 220 kann mehrere Isolationsmaterialschichten 220a, b umfassen. Zumindest eine Isolationsschicht 220a, b kann eine der Metallisierungsschichten 232a, b und eine der ersten oder zweiten Durchkontaktierungen 234a, b, 236a, b umfassen. Die Isolationsschichten 220a, b können als Trägerschichten zum Bilden der Metallisierungsanordnung 230 verwendet werden. Der Schritt des Bereitstellens 110 des Basissubstrats kann ein Bilden der in dem Isolationsmaterial 220 angeordnete strukturierte Metallisierungsanordnung 230 umfassen. Das Bilden einer Isolationsmaterialschicht 220a, b kann einen Bilden einer Metallisierungsschicht 232a mittels Fotolithografie und das Bilden erster Durchkontaktierungen 234a, b mittels Fotolithografie umfassen. Die Metallisierungsanordnung 230 kann zumindest eines aufweisen aus Gold, Kupfer, Nickel und Silber.

Fig. 2b zeigt einen schematischen Querschnitt eines Beispiels eines Basis-Substrats 202 mit Metallanschlussflächen 238a, b.

Ein an dem Isolationsmaterial 220 angeordneter Oberflächenbereich 224 des Basis-Substrats 202 (der der Halbleiterschicht 210 abgewandt ist) kann Metallanschlussflächen 238a, b (z. B. Bond-Pads) aufweisen. Zumindest eine (oder jede) der Metallanschlussflächen 238a, b ist elektrisch mit Metallisierungsanordnung 230 (z. B. mit den zweiten Durchkontaktierungen 236a) verbunden. Es können jedoch auch Metallanschlussflächen ohne elektrische Verbindung zur Metallisierungsanordnung 230 (z. B. zur Feldabschirmung) vorgesehen sein. Der Schritt des Bereitstellens 110 des Basissubstrats kann ein Bilden der Metallanschlussflächen 238a, b auf dem Oberflächenbereich 224 des Basis-Substrats 202 (z. B. mittels Fotolithographie) umfassen.

Die Metallanschlussflächen 238a, b können ein Verbinden des Isolationsmaterials 220 mit dem Isolationssubstrat 250 (z. B. mit Metallanschlussflächen des Isolationssubstrat 250) ermöglichen. Ferner können die Metallanschlussflächen 238a, b zur elektrischen Kontaktierung der Metallisierungsanordnung 230 verwendet werden.

Das Verfahren umfasst in einem Schritt 120 ein Bereitstellen eines Isolationssubstrats, das ein dielektrisches Material aufweist.

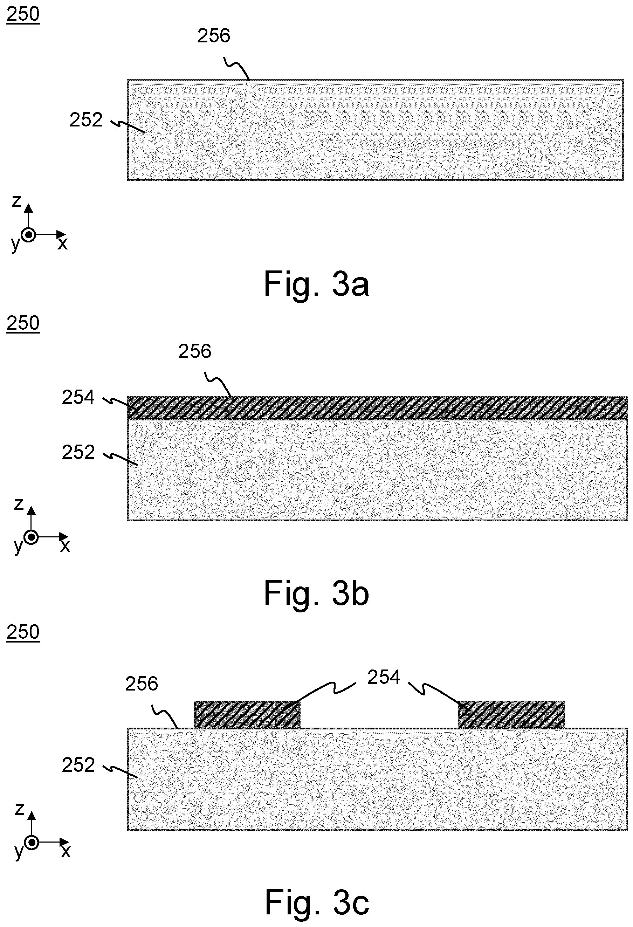

Fig. 3a zeigt einen schematischen Querschnitt eines Beispiels eines Isolationssubstrats 250 mit einem dielektrischen Material 252.

Das dielektrische Material des Isolationssubstrats 250 kann Glas, Diamant, Saphir, Korund oder Keramik aufweisen oder daraus geformt sein. Diese dielektrischen Materialien bilden einen guten Kompromiss aus Reduzierung von parasitären Kapazitäten, mechanischer Stabilität und Kompatibilität mit dem Basis-Substrat 202.

Das Isolationssubstrat 250 kann zumindest im Wesentlichen gleiche laterale Abmessungen (z. B. in Fig. 3a in x- und/oder z-Richtung) wie das Basis-Substrat 202 aufweisen. Das Isolationssubstrat 250 und das Basis-Substrat 202 können eine Plattenform (z. B. in Form eines Wafers) aufweisen. Das Isolationssubstrat 250 kann zugeordnete Metallanschlussflächen (Bond-Pads) aufweisen.

Fig. 3b zeigt einen schematischen Querschnitt eines Beispiels eines Isolationssubstrats 250 mit einer Metallanschlussfläche 254.

Die Metallanschlussfläche 254 bedeckt eine Oberfläche des Isolationssubstrats 250 vollständig. Eine derartige Metallanschlussfläche 254 kann aufgrund ihrer Größe eine elektrische Kontaktierung erleichtern.

Das Verfahren kann ein Anordnen der Metallanschlussfläche 254 auf der Oberfläche des Isolationssubstrats 250 umfassen.

Fig. 3c zeigt einen schematischen Querschnitt eines Beispiels eines Isolationssubstrats 250 mit mehreren Metallanschlussflächen 254. Mehrere Metallanschlussflächen 254 ermöglichen eine individuelle elektrische Kontaktierung und Ansteuerung.

Das Isolationssubstrats 250 weist einen Oberflächenbereich 256, der zumindest aus einem gebildet sein kann aus einer Oberfläche des dielektrischen Materials 252 und zumindest einer Metallanschlussflächen 254.

Das Isolationssubstrat 250 kann elektrische Leitungen aufweisen (in Fign. 3a-c nicht gezeigt), z. B. zum Leiten von Steuersignalen einer Steuervorrichtung an die Metallisierungsanordnung 230. Die elektrische Leitungen des Isolationssubstrats 250 können mit einer oder mehreren Metallanschlussflächen 254 elektrisch verbunden sein. Die elektrischen Leitungen des Isolationssubstrat 250 können zumindest teilweise entlang einer oder mehreren Oberflächen des Isolationssubstrats 250 und/oder innerhalb des Isolationssubstrats 250 verlaufen. Alternativ oder zusätzlich kann das Isolationssubstrat 220 elektrische Leitungen aufweisen, die elektrisch mit der Metallisierungsanordnung 230 verbunden sind. Die elektrischen Leitungen können lateral (in Fig. 2b in x- und/oder y-Richtung) verlaufen.

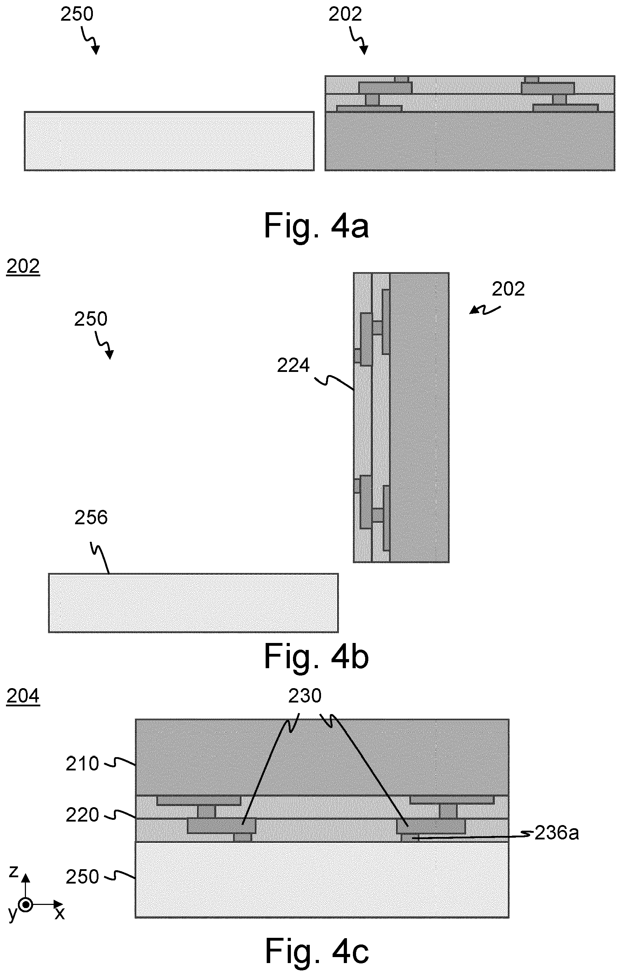

Fig. 4a-c zeigt einen schematischen Querschnitt von Anordnungen des Basis-Substrat 202 und des Isolationssubstrats 250. Das Anordnen wird beispielhaft anhand des Basis-Substrats 202 aus Fig. 2a und des Isolationssubstrats 250 aus Fig. 3a gezeigt. Es können jedoch jedes hierin beschriebene Basis-Substrat 202 und Isolationssubstrat 250 verwendet werden.

Fig. 4a zeigt einen schematischen Querschnitt einer getrennten Anordnung des Basis-Substrats 202 und des Isolationssubstrats 250. Das Basis-Substrats 202 kann mit dem Isolationssubstrat 250 (beispielsweise in einer Herstellungsvorrichtung) nach oben orientiert sein (z. B. aufgrund eines Beschichtungsverfahren zum Bilden des Isolationssubstrat 220 und/oder Schutz des Isolationssubstrat 220).

Fig. 4b zeigt einen schematischen Querschnitt eines Anordnens des Basis-Substrats 202 auf dem Isolationssubstrat 250. Dabei kann das Basis-Substrat 202 gedreht und der Oberflächenbereich 224 des Basis-Substrats 202 in Berührung mit dem Oberflächenbereich 256 des Isolationssubstrats 250 gebracht werden. Das Basis-Substrats 202 und das Isolationssubstrat 250 können jedoch auch in anderer Weise aneinander angeordnet werden (z. B. ein gemeinsames Rotieren nach Zusammenführen des Basis-Substrats 202 und des Isolationssubstrats 250).

Das Verfahren umfasst in einem Schritt 130 ein Verbinden des an dem Isolationsmaterial 220 angeordneten Oberflächenbereichs 224 des Basis-Substrats 202 mit dem Isolationssubstrat 250 mittels eines Bond-Vorgangs.

Fig. 4c zeigt einen schematischen Querschnitt eines Verbunds 204 des Basis-Substrats 202 mit dem Isolationssubstrat 250.

Das Durchführen des Bond-Vorgangs zwischen dem Isolationsmaterial 220 des Basis-Substrats 202 und dem Isolationssubstrat 250 kann mittels eines Oxid/Oxid-Bondvorgangs erfolgen oder zumindest einen Oxid/Oxid-Bondvorgang umfassen. Der Oxid/Oxid-Bondvorgang kann zumindest eines umfassen aus einem Erhitzen des Verbunds 204, einem Vibrieren des Verbunds 204 und einem Anlegen eines elektrischen Stroms an den Verbund 204. Der Oxid/Oxid-Bondvorgang kann ein Anordnen eines Verbindungsmittels zwischen dem Basis-Substrat 202 und dem Isolationssubstrat 250 umfassen.

Ein Oxid/Oxid-Bondvorgang ist mittels Standard-Halbleiterfertigungsprozessschritten realisierbar und erlaubt eine Verbindung mit hoher mechanischer Festigkeit. Ferner kann ein Oxid/Oxid-Bondvorgang die Verwendung von Metallen reduzieren (z. B. in Bereichen, in denen ein Kurzschluss entstehen könnte).

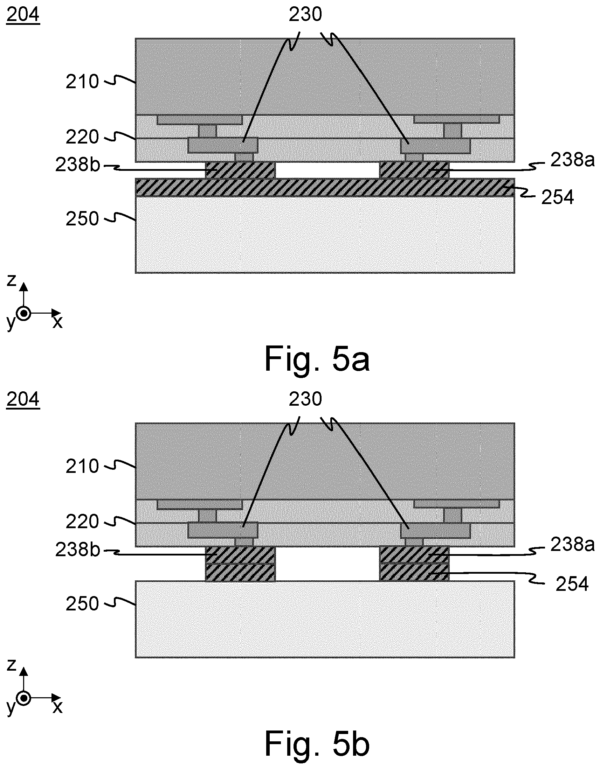

Fig. 5a zeigt einen schematischen Querschnitt eines Beispiels eines Verbunds 204 des Basis-Substrats 202 mit dem Isolationssubstrat 250 nach einem Metall-Bondvorgang. Das Basis-Substrat 202 weist Metallanschlussflächen 238a, b auf, wie hierein beispielsweise mit Bezug auf Fig. 2b beschrieben werden. Das Isolationssubstrat 250 weist eine Metallanschlussfläche auf, wie hierein beispielsweise mit Bezug auf Fig. 3b beschrieben wird.

Das Durchführen des Bondvorgangs zwischen dem Basis-Substrat 202 und dem Isolationssubstrat 250 kann an den zugeordneten Metallanschlussflächen 238a, b, 254 mittels eines Metall-Bondvorgangs erfolgen. Der Metall-Bondvorgang kann zumindest eines umfassen aus einem Erhitzen, einem Vibrieren und einem Anlegen eines elektrischen Stroms. Da die Metallanschlussfläche die gesamte (oder zumindest einen Großteil) einer Fläche des Isolationssubstrat 250 bedeckt, wird ein Ausrichten der Metallanschlussflächen 238a, b, 254 zueinander vereinfacht.

Das Durchführen des Metall-Bondvorgangs kann mittels Standard-Halbleiterfertigungsprozessschritten und somit präzise und skalierbar erfolgen. Ferner kann dadurch ein elektrischer Kontakt zum Ansteuern der Elektrodenstruktur realisiert werden.

Fig. 5b zeigt einen schematischen Querschnitt eines Beispiels eines Verbunds 204 des Basis-Substrats 202 mit dem Isolationssubstrat 250 nach einem Metall-Bondvorgang. Das Basis-Substrat 202 weist Metallanschlussflächen 238a, b auf, wie hierein beispielsweise mit Bezug auf Fig. 2b beschrieben werden. Das Isolationssubstrat 250 weist Metallanschlussflächen auf, wie hierein beispielsweise mit Bezug auf Fig. 3c beschrieben werden.

Das Durchführen des Bondvorgangs zwischen dem Basis-Substrat 202 und dem Isolationssubstrat 250 kann an den zugeordneten Metallanschlussflächen 238a, b, 254 mittels eines Metall-Bondvorgangs erfolgen. Der Metall-Bondvorgang kann zumindest eines umfassen aus einem Erhitzen, einem Vibrieren und einem Anlegen eines elektrischen Stroms. Die Mehrzahl von Metallanschlussflächen 238a, b, 254 erlaubt ein Anlegen verschiedener elektrischer Signale an verschiedene Komponenten der Metallisierungsanordnung 230 (beispielsweise zur Erzeugen von elektrischen Feldern in einer Ionenfalle).

Der Bond-Vorgang kann als Kombination (Hybrid-Bondvorgang) eines Oxid/Oxid-Bondvorgangs und eines Metall-Bondvorgangs durchgeführt werden. Ein Oxid/Oxid-Bondvorgang kann beispielsweise zwischen dem Isolationsmaterial 220 und dem Isolationssubstrat 250 erfolgen. Ein Metall-Bondvorgang kann beispielsweise zwischen der Metallisierungsanordnung 230 (z. B. einer zweiten Durchkontaktierung 236a und, einer sich zum Oberflächenbereich 224 des Basis-Substrats 202 erstreckenden Metallisierungsschichten oder Metallanschlussflächen 238a, b) und einer oder mehrerer Metallanschlussflächen 254 des Isolationssubstrats 250 erfolgen.

Eine Kombination (Hybrid-Bondvorgang) eines Oxid/Oxid-Bondvorgangs und eines Metall-Bondvorgangs erlaubt eine flexiblere Auswahl von Verbindungsarten zwischen verschiedenen Strukturen des Isolationsmaterials 220 und des Isolationssubstrats 250. Dadurch können beispielsweise gezielt elektrische Kontakte mittels des Metall-Bondvorgang realisiert werden und ungewollte Metallkontakte mittels des Oxid/Oxid-Bondvorgangs reduziert werden.

Das Verfahren umfasst in einem Schritt 140 Rückdünnen des Basis-Substrats 202 durch Entfernern der Halbleiterschicht 210 bis zu dem Isolationsmaterial 220 des Basis-Substrats 202. Die Elektrodenstruktur für die Ionenfalle wird gebildet, indem der Schritt 140 des Rückdünnes bis zu der Metallisierungsanordnung 230 durchgeführt wird, oder indem eine strukturierte Oberflächenmetallisierung auf das Isolationsmaterial 220 des rückgedünnten Basis-Substrats 202 aufgebracht wird wobei die Elektrodenstruktur für die Ionenfalle durch die strukturierte Metallisierungsanordnung gebildet wird.

Das Basis-Substrat 202 kann während der Schritte des Verbindens mit dem Isolationssubstrat 250 und/oder des Rückdünnens des Basis-Substrats 202 auf einem Trägersubstrat, z.B. aus einem dielektrisches Material, wie Glas, Diamant, Saphir, Korund oder Keramik, fixiert sein. Das Trägersubstrat erleichtert die Handhabung und ermöglicht das gleichzeitige Prozessieren einer Vielzahl von Basis-Substraten 202.

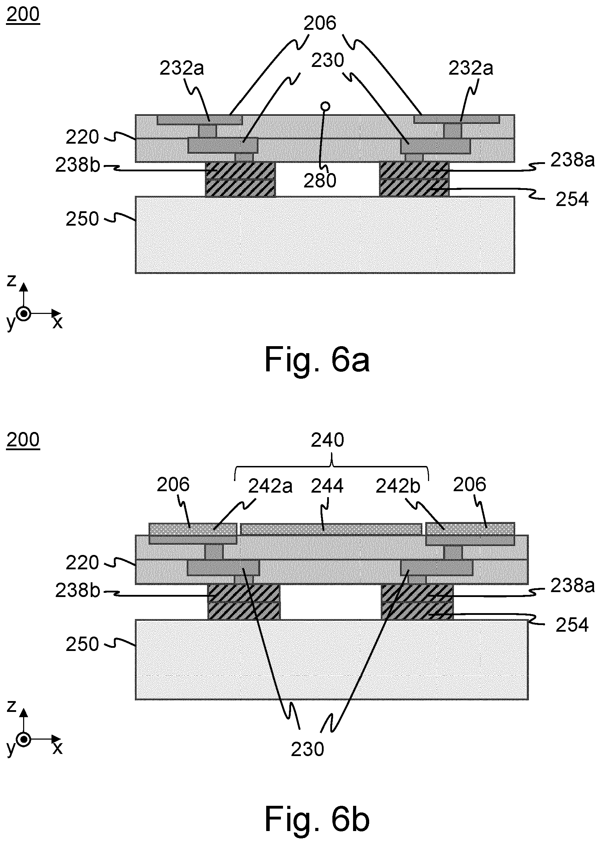

Fign. 6a, b zeigen einen schematischen Querschnitt von Beispielen einer Elektrodenvorrichtung 200 mit einer Elektrodenstruktur 206 für eine Ionenfalle. Das Beispiel der Elektrodenvorrichtung 200 aus Fig. 6a kann beispielsweise mittels eines Rückdünnens des Verbunds 204 aus Fig. 5b realisiert werden. Die hierin beschriebene Offenbarung beschränkt sich jedoch nicht darauf.

Fig. 6a zeigt einen schematischen Querschnitt eines Beispiels, in dem die Elektrodenstruktur 206 für die Ionenfalle gebildet wird, indem der Schritt des Rückdünnes bis zu der Metallisierungsanordnung 230 durchgeführt wird. Dadurch werden oberste Metallflächen 232a der Metallisierungsanordnung 230 aus dem Isolationsmaterial 220 freigelegt, welche die Elektrodenstruktur 206 (z. B. in Form von Oberflächenelektroden) bilden. Die Elektrodenstruktur 206 kann ein, zwei, drei, vier oder mehr Oberflächenelektroden aufweisen. Das Beispiel der Elektrodenstruktur 206, die in Fig. 6a gezeigt wird, weist zwei Oberflächenelektroden auf, die aus der Metallisierungsschicht 232a geformt sind. Durch Anlegen eines elektrischen Signals an die Metallisierungsanordnung 230 (z. B. über zumindest eines aus Metallanschlussflächen 238a, b, 254 und elektrischen Leitungen des Isolationssubstrat 250) kann von der Elektrodenstruktur 206 ein elektrisches Feld erzeugt werden. Das elektrische Feld kann verwendet werden um eine Position eines Ions 280 zu steuern.

Die freigelegte Metallisierungsschicht (z. B. Metallisierungsschicht 232a in Fig. 6a) der Metallisierungsanordnung 230 kann die Elektrodenstruktur für eine Oberflächen-Ionenfalle bilden. Die freigelegten Metallisierungsschichten 232a können dazu in einer gemeinsamen Ebene liegen. Die freigelegten Metallisierungsschichten 232a, b können mit einem elektrischen Signal angesteuert werden, um ein elektrisches Feld zu erzeugen, dass ein Ion in eine Position nahe der freigelegten Metallisierungsschicht 232a beispielsweise in einer Lücke zwischen zwei Oberflächenelektroden und beabstandet vom Isolationsmaterial 220 hält. Die freigelegten Metallisierungsschichten 232a können beispielsweise einen Abstand zwischen 50 bis 400µm, z. B. zwischen 100µm und 200µm aufweisen.

Das Rückdünnen erlaubt das Bilden einer zumindest im Wesentlichen flachen Oberfläche, so dass die freigelegte Metallisierungsschicht oder die aufgebrachte, strukturierte Oberflächenmetallisierung ebenfalls in einer flachen Ebene angeordnet werden können. Somit können über die daraus gebildete Elektrodenstruktur elektrische Felder mit guter Präzision erzeugt werden, welche für eine Oberflächen-Falle von Vorteil ist.

Fig. 6b zeigt einen schematischen Querschnitt eines Beispiels, in dem die Elektrodenstruktur 206 für die Ionenfalle gebildet wird, indem eine strukturierte Oberflächenmetallisierung 240 auf das Isolationsmaterial 220 des rückgedünnten Basis-Substrats 202 aufgebracht wird. Die Oberflächenmetallisierung 240 umfasst einen ersten Metallisierungsteil 242a, b, der mit der Metallisierungsanordnung 230 (z. B. mit zumindest einer Metallisierungsschicht 232a oder einer zweiten Durchkontaktierung 236a) elektrisch verbunden ist. Die Elektrodenstruktur 206 kann in diesem Fall von dem ersten Metallisierungsteil 242a, b geformt werden. Die Oberflächenmetallisierung 240 umfasst einen zweiten Metallisierungsteil 244, der elektrisch von der Metallisierungsanordnung 230 isoliert ist. Durch Anlegen eines elektrischen Signals an die Metallisierungsanordnung 230 (z. B. über zumindest eines aus Metallanschlussflächen 238a, b, 254 und elektrischen Leitungen des Isolationssubstrat 250) kann ein elektrischen Feld von der Elektrodenstruktur 206 (z. B. des ersten Metallisierungsteils 242a, b) erzeugt werden. Der zweite Metallisierungsteil 244 kann eine elektrische Abschirmung verbessern.

Die Oberflächenmetallisierung 240 in Fig. 6b weist erste und zweite Metallisierungsteile 242a, b, 244 auf. Alternativ kann die Oberflächenmetallisierung 240 nur erste Metallisierungsteile 242a, b aufweisen. Eine zweite Metallisierung 244 kann auch für andere bei anderen hierin beschriebenen Elektrodenvorrichtung 200 durchgeführt werden.

Die Metallanschlussflächen 238a, b, 254 in Fign. 5a-6b sind erhaben (über Oberflächen des Isolationsmaterial 220 und des Isolationssubstrats 250 hervorstehend) ausgebildet. Alternativ kann zumindest eine (oder alle) Metallanschlussflächen 238a, b, 254 bündig mit den Oberflächen des Isolationsmaterial 220 und des Isolationssubstrats 250 (oder darin versenkt) ausgebildet sein.

Die aufgebrachte, strukturierte Oberflächenmetallisierung 240 (z. B. die ersten Metallisierungsteile 242a, b) auf dem Isolationsmaterial 220 des rückgedünnten Basis-Substrats 202 kann die Elektrodenstruktur 206 für eine Oberflächen-Ionenfalle bilden. Die Oberflächenmetallisierung 240 (z. B. die ersten Metallisierungsteile 242a, b) kann mit einem elektrischen Signal angesteuert werden, um ein elektrisches Feld zu erzeugen, dass ein Ion in eine Position nahe der strukturierte Oberflächenmetallisierung 240 (z. B. zwischen den ersten Metallisierungsteilen 242a, b) hält. Zwei erste Metallisierungsteile 242a, b können beispielsweise einen Abstand zwischen 50 bis 400µm, z. B. zwischen 100µm und 200µm aufweisen.

Der Schritt des Rückdünnes kann bis zu einer obersten (oder einer des Isolationssubstrats 250 am entferntesten angeordneten), strukturierten Metallisierungsschicht (z. B. zumindest eine der Metallisierungsschichten 236a, b) der Mehrlagenmetallisierungsanordnung 230 durchgeführt werden.

Bei dem Schritt des Rückdünnens des Basis-Substrats 202 kann die Halbleiterschicht 210 des Basis-Substrats 202 vollständig (oder nahezu vollständig, wie beispielsweise 99% oder über 99,9%) entfernt werden.

Durch das vollständige Entfernen der Halbleiterschicht 210 können Probleme, die durch das Halbleitermaterial erzeugt werden (z. B. parasitäre Kapazitäten und Einflüsse auf elektrische Felder), vollständig eliminiert werden. Ferner wird eine Oberfläche des rückgedünnten Basis-Substrats 202 durch eine Oberfläche des Isolationsmaterials 220 (oder anderen Zwischenschichten wie eine Oxidschicht des Halbleitermaterials) gebildet, so dass die Oberfläche des Basis-Substrats 202 (zumindest vornehmlich) über die Oberfläche des Isolationsmaterials 220 und nicht nur über das Rückdünnen gesteuert werden kann.

Das Rückdünnen kann ein Entfernen eines Teils (z. B. des Dielektrikums des Isolationsmaterial 220 und/oder einer optionalen Oxidschicht zwischen dem Dielektrikum und der Halbleiterschicht 210) umfassen. Das Isolationsmaterial 220 kann weniger als 1µm oder weniger als 0,1µm rückgedünnt werden.

Das Rückdünnen kann mindestens eines umfassen aus Trockenätzen, Nassätzen und Zurückpolieren (z. B. chemisch-mechanisches Polieren).

Das Verfahren zur Herstellung der Elektrodenstruktur 200 für eine Ionenfalle kann mittels Standard-Halbleiterfertigungsprozessschritten durchgeführt werden. Ferner kann das Basis-Substrat mittels Standard-Halbleiterfertigungsprozessschritten hergestellt werden. Das Verfahren ermöglicht jedoch das Basis-Substrats 202 rückzudünnen, so dass der Materialanteil der Halbleiterschicht 210 signifikant verringert oder vollständig entfernt wird. Übliche Materialien, die in Standard-Halbleiterfertigungsprozessschritten verwendet werden, wie beispielsweise Silizium, können zu parasitären Kapazitäten führen, welche manche Anwendungen, wie beispielsweise die Verwendung in einer Ionenfalle, beeinträchtigen. Das Verfahren ermöglicht somit das Herstellen der Elektrodenstruktur 200 durch effiziente und genaue Herstellungsverfahren und reduziert oder eliminiert Nachteile, die Materialien des Herstellungsverfahren verursachen könne.

Die in dem Isolationsmaterial 220 eingebettete Metallisierungsanordnung 230 kann als Antennenstruktur zum Bereitstellen elektrischer Felder für die Ionenfalle ausgebildet sein. An die Metallisierungsanordnung 230 kann ein konstantes Signal (z. B. konstante Spannung) oder ein wechselndes Signal (z. B. wechselnde Spannung) angelegt werden. Es kann mittels eines Teils der Elektrodenstruktur 206 ein konstantes Feld (DC-Feld) und mittels eines anderen Teils der Elektrodenstruktur 206 ein wechselndes Feld (RF-Feld) erzeugt werden. Die Metallisierungsanordnung 230 kann als Antennenstruktur aufgrund dieser Signale elektrische Felder erzeugen.

Da Ionenfallen anfällig für parasitäre Kapazitäten sein können, kann die Verwendung der Metallisierungsanordnung 230 als Antennenstruktur den Betrieb einer Ionenfalle verbessern. Insbesondere können dadurch Kohärenzzeiten von Ionenzustände verlängert werden.

Die Ionenfalle kann für Quantencomputeranwendungen vorgesehen sein. Da quantenmechanische Berechnungen innerhalb der Kohärenzzeit möglich sind, kann eine Ionenfalle mit der hierein beschriebenen Elektrodenstruktur komplexere Quantencomputeranwendungen ermöglichen.

Das Verfahren kann ferner umfassen einen Schritt für ein Ausbilden einer Ausnehmung in Form eines Lochs oder Grabens in dem Basis-Substrat 202 durch das Isolationsmaterial 220 der Metallisierungsanordnung 230 (hindurch bis) zu der Halbleiterschicht.

Da die Ausnehmung sich durch das Isolationsmaterial der Metallisierungsanordnung 230 (z. B. Mehrlagenmetallisierungsanordnung) erstreckt, kann die Ausnehmung ein Volumen bilden, dass in dem durch die Elektrodenstruktur (und optional durch innerhalb des Isolationsmaterial angeordnete Teile der Mehrlagenmetallisierungsanordnung) elektrische Felder erzeugt werden, die ein Positionieren eines Ions innerhalb der Ausnehmung ermöglichen. Aufgrund der hierin beschriebenen Herstellung können die Elektrodenstrukturen präzise geformt werden und erlauben eine gute Kontrolle über elektrische Felder innerhalb der Ausnehmung.

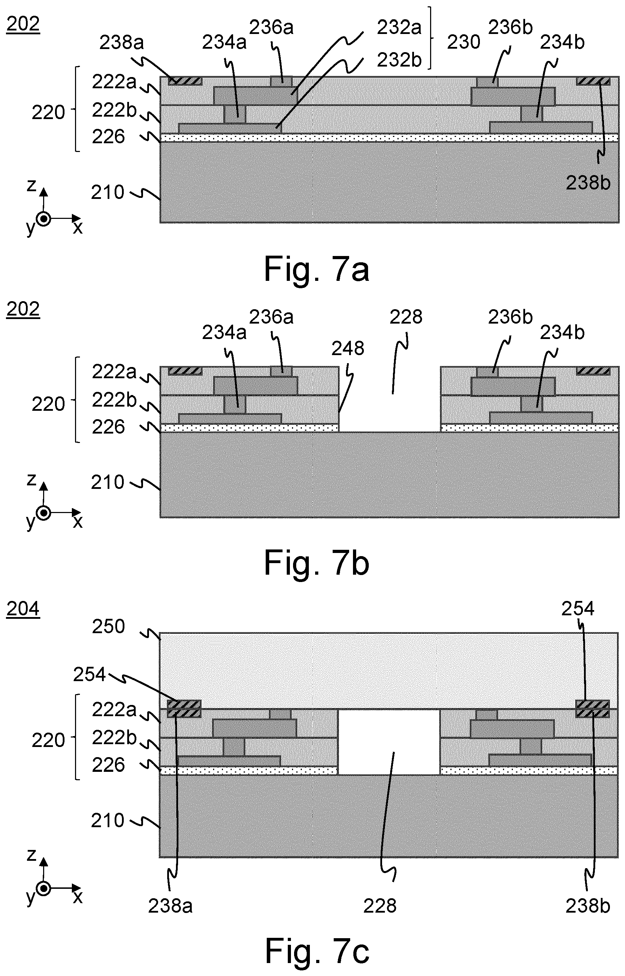

Fig. 7a zeigt einen schematischen Querschnitt eines Beispiels für ein Basis-Substrat 202 vor einem Ausbilden einer Ausnehmung. Die Ausnehmung kann in jedem hierin beschriebenen Basis-Substrat 202 (oder Verbund 204) ausgebildet werden. Das Basis-Substrat 202 im Beispiel der Fig. 7a kann eine Implementierung des Basis-Substrats 202 aus Fig. 2a sein, wobei das Isolationsmaterial 220 ferner eine auf einer der Halbleiterschicht 210 zugewandten Seite eine Oxidschicht 226 (IC-Isolationsoxid, beispielsweise ein Oxid eines Materials der Halbleiterschicht) aufweist. Das Isolationsmaterial 220 in Fig. 7b kann auch keine Oxidschicht 226 aufweisen. Die Oxidschicht 226 kann Teil jedes hierin beschriebene Isolationsmaterials 220 sein.

Fig. 7b zeigt einen schematischen Querschnitt des Basis-Substrats 202 aus Fig. 7a nach einem Ausbilden einer Ausnehmung 228.

Die Ausnehmung 228 kann auch zu einem anderen Zeitpunkt erfolgen. So kann die Ausnehmung 228 beispielsweise nach den Schritten 130 (Verbinden des Basis-Substrats 202 mit dem Isolationssubstrat 250) und 140 (Rückdünnen des Basis-Substrats 202) ausgebildet werden.

Der Schritt des Ausbildens der Ausnehmung 228 kann mittels einer Loch- oder Grabenätzung durchgeführt werden. Die Ausnehmung 228 kann sich auch in oder durch die Halbleiterschicht 210 erstrecken. Die Ausnehmung 228 kann die Form eines Zylinders oder Würfels aufweisen. Die Ausnehmung 228 kann einen länglichen quaderförmigen Querschnitt aufweisen (z. B. mit einer längsten Erstreckung in Fig. 7b in y-Richtung). Die Ausnehmung 228 kann sich in laterale Richtung (in Fig. 7b in x- und/oder y-Richtung) vollständig durch das Isolationsmaterial 220 erstrecken.

Eine Loch- oder Grabenätzung ermöglicht eine präzise Bildung der Ausnehmung und kann mittels Standard-Halbleiterfertigungsprozessschritten durchgeführt werden.

Die Ausnehmung 228 weist Seitenwände 248 auf. Die Seitenwände 248 können eben oder rund ausgebildet sein. Die Seitenwände 248 können separat von der Metallisierungsanordnung 230 angeordnet sein. In anderen Worten, die Ausnehmung 228 kann derart geformt sein, dass die Ausnehmung 228 nicht die Metallisierungsanordnung 230 schneidet.

Fig. 7c zeigt einen schematischen Querschnitt eines Verbunds 204 nach einem Verbinden des Basis-Substrats 202 aus Fig. 7b mit einem Isolationssubstrat 250.

In dem Beispiel in Fig. 7b weist das Basis-Substrats 202 bündige Metallanschlussflächen 238a, b auf und das Isolationssubstrat 250 weist bündige Metallanschlussflächen 254 auf. Das Verbinden des Basis-Substrats 202 mit einem Isolationssubstrat 250 kann mittels eines Metall-Bondvorgangs zwischen den Metallanschlussflächen 238a, b, 254 erfolgen. Alternativ kann das Verbinden mittels eines anderen hierein beschriebenen Bondvorgangs erfolgen. Das Basis-Substrats 202 und/oder Isolationssubstrat 250 kann jedoch jede hierin beschriebene Metallanschlussfläche 238a, b, 254 aufweisen. Ferner kann jede hierein beschriebene Basis-Substrats 202 und/oder Isolationssubstrat 250 bündige Metallanschlussflächen 238a, b, 254 aufweisen.

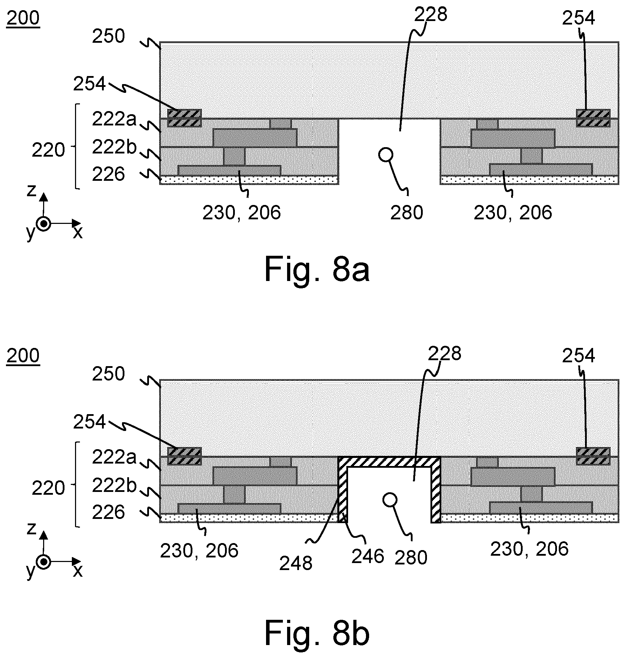

Fig. 8a zeigt einen schematischen Querschnitt einer Elektrodenvorrichtung 200 mit dem Verbund aus Fig. 7c nach einem Rückdünnen des Basis-Substrats 202 durch Entfernern der Halbleiterschicht 210 bis zu dem Isolationsmaterial 220 des Basis-Substrats 202.

Die Elektrodenstruktur 206 für die Ionenfalle wird durch die strukturierte Metallisierungsanordnung 230 gebildet. Im Beispiel, das in Fig. 8a gezeigt wird, wurde das Rückdünnen bis zu der (oder teilweise in die) Oxidschicht 226 durchgeführt. Die Metallisierungsanordnung 230 kann elektrische Felder außerhalb des Isolationsmaterials 220 erzeugen, ohne aus der Isolationsmaterials 220 hervorzustehen. Die Metallisierungsanordnung 230 kann beispielsweise elektrische Felder innerhalb der (von der Metallisierungsanordnung 230 umgebenen oder der Metallisierungsanordnung 230 benachbarten) Ausnehmung 228 zum Steuern einer Position eines Ions 280 innerhalb der Ausnehmung 228 erzeugen.

Alternativ kann die Oxidschicht 223 im Rahmen des Rückdünnens oder eines separaten Ätzprozesses entfernt werden. Optional kann eine Oberflächenmetallisierung auf der dem Isolationsmaterial (z. B. zur Abschirmung oder in elektrischem Kontakt mit der Metallisierungsanordnung 230) aufgebracht werden.

Fig. 8b zeigt einen schematischen Querschnitt der Elektrodenvorrichtung 200 aus Fig. 8a nach einem Anordnen einer Metallisierung.

Das Verfahren kann ferner umfassen einen Schritt eines Anordnen einer Metallisierung 246 bereichsweise oder vollständig an Seitenwänden 248 der Ausnehmung 228 in dem Isolationsmaterial 220 des rückgedünnten Basis-Substrats 202. Die Metallisierung 246 kann auf einer Oberfläche des Dielektrikum des Isolationsmaterial 220 angeordnet sein. Alternativ oder zusätzlich kann die Metallisierung 246 kann auf einer Oberfläche des Isolationssubstrats 250 (die die Ausnehmung 228 begrenzt) angeordnet sein. Falls das Isolationsmaterial 220 eine Oxidschicht 226 aufweist, kann die Metallisierung 246 zusätzlich auf die Seitenwand 248 der Oxidschicht 226 angeordnet sein. Im Beispiel, das in Fig. 8b gezeigt wird, ist die Metallisierung 246 auf Oberflächen des Isolationsmaterials 220, des Isolationssubstrats 250 und der Oxidschicht 226 angeordnet. Die Metallisierung 246 kann eine elektrische Abschirmung des Ausnehmung 228 verbessern. Dazu kann die Metallisierung 246 mit einem Bezugspotential (V_{BEZUC} ≠ 0V) oder mit Massepotential (V_{MA} = 0V) elektrisch verbunden sein. Das Anordnungen der Metallisierung kann auch zu einem früheren Zeitpunkt, wie beispielsweise vor dem Verbinden mit dem Isolationssubstrat 250 oder dem Rückdünnen des Standard-Substrats 202, erfolgen.

Die Metallisierung 246 kann beispielweise strukturiert ausgebildet werden (z. B. mittels optischer Lithographie). Die Metallisierung 246 kann eine oder mehrere Aussparungen (z. B. Löcher und/oder einen zurückstehenden Rand) aufweisen. Die Aussparungen können symmetrisch bezüglich einer Symmetrieachse der Ausnehmung 228 angeordnet sein (z. B. rotationssymmetrisch bezüglich einer Achse einer zylinderförmigen Ausnehmung oder spiegelsymmetrisch bezüglich einer Spiegelachse einer länglichen oder quaderförmigen Ausnehmung). Die Metallisierung 246 kann Strukturen an zumindest einer Seitenwand 248 und/oder einer der Oberfläche des Isolationssubstrats 250 aufweisen. Eine strukturierte Metallisierung 246 kann ein Formen von (z. B. von der Elektrodenstruktur 206 erzeugten) elektrischen Feldern ermöglichen oder verbessern.

Die Metallisierung 246 kann so ausgebildet und strukturiert sein, dass eine Einkopplung eines elektrischen (oder elektromagnetischen) Feldes in die Ausnehmung 228 möglich ist. Damit kann die Elektrodenanordnung 208, die die Elektrodenstrukturen 206-1, 206-2 aufweist, elektrische Felder bereitstellen, die beispielsweise zum Steuern einer Position eines Ions 280 verwendet werden können.

Jede hierein beschriebene Elektrodenvorrichtung 200 (sowie eine nachfolgend beschriebene Elektrodensystem 400) kann eine Ionenfalle (z. B. eine zweidimensionale und/oder dreidimensionale Ionenfalle) bilden (oder zumindest ein Teil einer Ionenfalle sein). Jedes hierin beschriebene Verfahren zur Herstellung einer Elektrodenvorrichtung oder Elektrodensystem kann ein Verfahren zum Herstellen einer (z. B. einer zweidimensionale und/oder dreidimensionale) Ionenfalle sein oder ein Verfahren zum Herstellen einer Ionenfalle umfassen. Das Verfahren kann ein elektrisches Koppeln der Elektrodenstruktur (oder Elektrodenanordnung) an eine Spannungsversorgung aufweisen. Die Spannungsversorgung kann ausgebildet sein, Spannungen bereitzustellen, welche an der Elektrodenstruktur (oder Elektrodenanordnung) zur Erzeugung von elektrischen Feldern führt. Die elektrischen Felder können ausgebildet sein, um eine Position eines Ions steuern kann (z. B. mittels eines Bereitstellens einer Wechselspannung und/oder einer Gleichspannung).

Da das Basis-Substrat (zumindest vor dem Rückdünnen) eine Halbleiterschicht aufweist, kann das Isolationsmaterial und/oder die Metallisierungsanordnung über Haltleiterprozessschritte hergestellt werden. Derartige Herstellungsverfahren können verschieden Vorteile aufweisen, wie beispielsweise eine Verbesserung einer Präzision, einer Automatisierung und/oder eines Strukturierungsprozesses, sowie verbesserte Wachstumsbedingungen (z. B. ein Wachsen auf einkristallinem Silizium und Formen präziser Oxidschichten, beispielsweise für das Isolationsmaterial). Aufgrund des Verbindens mit dem Isolationssubstrats und des Rückdünnens kann die Halbleiterschicht vollständig oder zumindest zum Teil entfernt werden, so dass der Einfluss der Halbleiterschicht reduziert werden kann. Eine Ionenfalle mit der Elektrodenvorrichtung 200 (oder dem Elektrodensystem 400) weist eine rückgedünnte Halbleiterschicht auf, so dass der Einfluss von Halbleitermaterialien wie beispielweise Silizium reduziert oder vermieden werden kann. So kann beispielsweise die Bildung von parasitären Kapazitäten reduziert werden. Das Verfahren ermöglicht beispielsweise ein Wechsel des Substratmaterials von Silizium auf Glas, Quarz oder Saphir.

Gemäß einer Ausführungsform wird ein Verfahren zur Herstellung einer Ionenfalle vorgestellt. Das Verfahren zur Herstellung einer Ionenfalle kann (teilweise oder vollständig) mittels Halbleiterfertigungsprozessen erfolgen. Die Ionenfalle kann für Quantum Computer Anwendungen vorgesehen sein. Das Verfahren kann zur Herstellung einer 3-dimensionalen Ionenfalle verwendet werden, bzw. ein Herstellen einer 3-dimensionalen Ionenfalle umfassen.

Ein Vorteil der vorliegenden Erfindung ist die potentielle Nutzung von Standardhalbleiterprozesselementen. Üblicherweise werden Ionenfallen durch komplexere, kostenaufwändige und aufwändigere Mikroprozesstechnik und Metallisierungsprozesse hergestellt. Die Erfindung ermöglicht somit eine kostengünstigere Herstellung von lonenfallen und darüber hinaus vor allem eine wesentlich höhere Qualität und Zuverlässigkeit der Produkte.

Gemäß einer Ausführungsform weist ein Verfahren zur Herstellung einer Ionenfalle (z. B. für Quantencomputeranwendungen) folgende Schritten auf: Bereitstellung eines Substrats aus Standard-Halbleiterfertigung (z. B. Basis-Substrat 202, z. B. IC-Substrat), welches eine IC Mehrlagenmetallisierung (z. B. Metallisierungsanordnung 230) und optionale Metallisierungs-Strukturen (z. B. Metallanschlussflächen 238b) für einen Substrat-Bondprozess enthält (Metall-Bondpads).

Das Verfahren kann umfassen ein Herstellen (z. B. Ausnehmen) eines Grabens (z. B. Ausnehmung 228) durch ein oder mehrere Dielektrika (z. B. Isolationsmaterial 220) des IC-Substrats (z. B. Basis-Substrat 202). Ferner kann das Verfahren umfassen ein Verbinden (z. B. Bonden) des IC-Substrats (z. B. Basis-Substrat 202) mit einem zweiten Substrat (z. B. Isolationssubstrat 250) welches eine dielektrische Oberfläche aufweist (Isolationssubstrat) zu einem Substratstapel. Das Verbinden kann erfolgen mittels Oxid/Oxid Bonding und den Metall-Bondpads (z. B. Metallanschlussflächen 238b) auf der Vorderseite (Hybrid-Bondverfahren). Das Verfahren kann umfassen ein Rückdünnen des Substrat-Stapels (z. B. umfassend das Basis-Substrat 202 und das Isolationssubstrat 250) bis auf die dielektrische Schicht (z. B. Isolationsmaterial 220), so dass die Halbleiterschicht (z. B. Halbleiterschicht 210) des IC-Substrats (z. B. Basis-Substrat 202) vollständig (oder teilweise) entfernt ist.

Das Rückdünnen kann an einer dem Isolationssubstrats abgewandten Oberfläche der Halbleiterschicht erfolgen. Das Rückdünnen kann über die abgewandte Oberfläche der Halbleiterschicht hinweg gleichmäßig (z. B. ohne Strukturierung und/oder Maskierung) erfolgen. In anderen Worten, eine Dicke das Basis-Substrats kann durch das Rückdünnen gleichmäßg reduziert werden. Das Basis-Substrat (z.B. ein Rest der Halbleiterschicht 210 oder des Isolationsmaterials 252) kann an einer rückgedünnten Seite (z. B. auf einer dem Isolationssubstrat 250 abgewandten Seite) eine (z. B. einzige) ebene Fläche bilden.

Das IC-Subtrat (z. B. Basis-Substrat 202) kann beispielsweise ein Isolationsoxid, ein oder mehrere Inter-Metall-Dielektrika (z. B. Isolationsmaterial 220), eine Metallisierung (z. B. Metallisierungsanordnung 230) und Metall-Bond-Pads (z. B. Metallanschlussflächen 238b) aufweisen. Das IC-Substrat kann mittels einer Standard-Halbleiterfertigung hergestellt werden. Optional kann eine Grabenätzung durch das eine oder die mehreren Dielektrika (z. B. bis auf das IC-Substrat) erfolgen. Das Verfahren kann ein Bonden einer Vorderseite zu einem Isolationssubstrat umfassen (z. B. per Oxid/Oxid-Boden oder Metall-Hybrid-Bonden.

Gemäß einem Ausführungsbeispiel wird beispielweise ein 3D Integrationssystem realisiert mit Interconnects mit nachfolgenden Eigenschaften. Ein Aufbau von Oberflächenionenfallen kann realisiert werden mittels Einfach- und/oder Multilagenmetallisierung auf Glass-, Quarz-, Saphir- oder Keramiksubstrat. Zur Optimierung von DC-/RF-Feldern können grautonlithographische Methoden angewendet werden, um Metalloberflächen (z. B. von Elektrodenstruktur 206 und/oder Elektrodenanordnung 208) 3-dimensional zu strukturieren. Eine 3-dimensionale Paul-Ionenfallen-Anordnung kann aus der Verbindung zweier oder mehrerer Oberflächenionenfallen (z. B. aus zwei oder mehr Elektrodenstrukturen 206 oder Ionenfallen mit Elektrodenstrukturen 206) aufgebaut werden. Eine mechanische und/oder elektrische Verbindung der lonenfallen zu einem Träger, welches auch eine Oberflächenionenfalle darstellen kann, kann mittels Interconnects gewährleistet (z. B. realisiert) werden. Gemäß einem Ausführungsbeispiel wird ein Verfahren zur Herstellung von Oberflächenionenfallen bereitgestellt, z. B. mittels Einfach- und/oder Multilagenmetallisierung auf Glass-, Quarz, Korund, Diamant- oder Keramiksubstrat. Ein Aufbau einer 3-dimensionalen Ionenfallen-Anordnung kann eine oder mehrere Oberflächenionenfallen aufweisen. Das Verfahren kann ein 3-dimensionales Strukturieren einer Elektrodentopographie mittels Grautonlithographie umfassen, um Eigenschaften der elektrischen Felder zu verändern.

Eine weitere Herangehensweise zum Herstellen einer 3-dimensionale Falle beinhaltet ein Verbinden einer Elektrodenvorrichtung mit einer weiteren Elektrodenvorrichtung. Für das nachfolgend beschriebene Verfahren 300 zur Herstellen der 3-dimensionale Falle sind die oben beschriebenen Schritte des Verfahrens 100 gleichermaßen teilweise oder vollständig und in jeder Kombination einsetzbar und anwendbar. Strukturen, die in der oben beschriebenen Elektrodenstruktur beschrieben sind, können in der 3-dimensionalen Falle teilweise oder vollständig und in jeder Kombination realisiert werden. Die oben beschriebenen technischen Effekte gelten auch für die nachfolgend beschriebenen Ausführungsbeispiele.

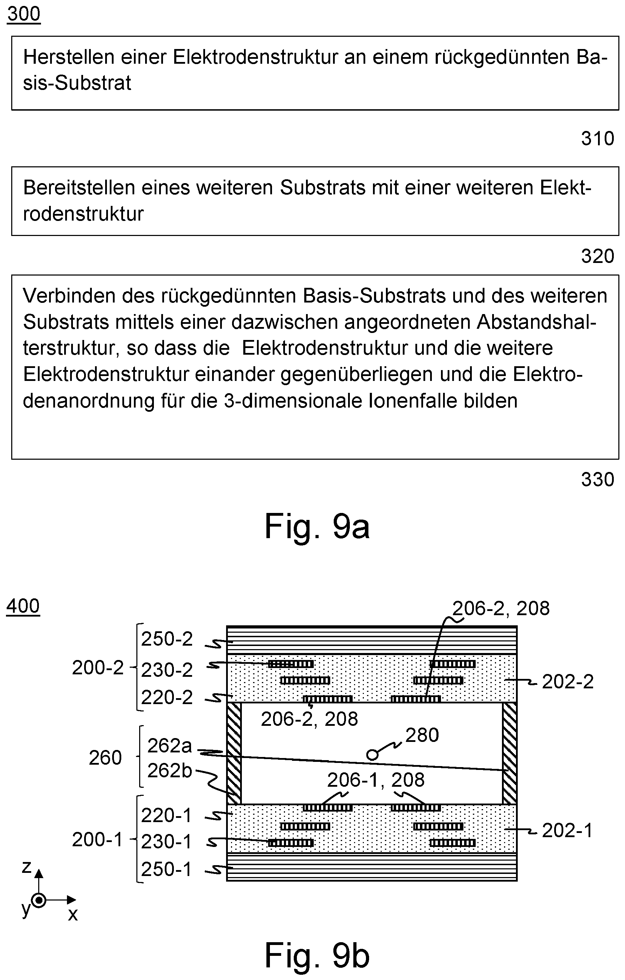

Fig. 9a zeigt ein schematisches Flussdiagramm 300 des erfindungsgemäßen Herstellungsverfahrens gemäß einem Ausführungsbeispiel. Das Verfahren 300 wird genutzt zur Herstellung einer Elektrodenanordnung für eine 3-dimensionale Ionenfalle.

Das Verfahren umfasst in einem Schritt 310 ein Durchführen des Verfahrens 100 (mit den Schritten 110, 120, 130, 140) wie hierin beschrieben, um eine Elektrodenstruktur (für eine Ionenfalle) an einem rückgedünnten Basis-Substrat herzustellen.

Schritt 310 umfasst daher ein Bereitstellen eines Basis-Substrats (siehe auch Schritt 110 von Fig. 1), das auf einer Halbleiterschicht eine in einem Isolationsmaterial angeordnete strukturierte Metallisierungsanordnung aufweist. Fign. 2a und 2b zeigen Beispiele für ein Basis-Substrat 202.

Schritt 310 umfasst ein Bereitstellen eines Isolationssubstrats (siehe auch Schritt 120 von Fig. 1), das ein dielektrisches Material aufweist. Fign. 3a bis c zeigen Beispiele für ein Isolationssubstrat 250.

Schritt 310 umfasst ferner ein Verbinden des an dem Isolationsmaterial angeordneten Oberflächenbereichs 224 des Basis-Substrats 202 mit dem Isolationssubstrat 250 mittels eines Bond-Vorgangs (siehe auch Schritt 130 von Fig. 1). Fign. 4 und 4b zeigen Beispiele für ein Anordnen des Basis-Substrat 202 an das Isolationssubstrat 250. Fign. 4c, 5a und 5b zeigen Beispiele eines Verbunds 204 umfassend das Basis-Substrat 202 und das Isolationssubstrat 250.

Schritt 310 umfasst zudem ein Rückdünnen des Basis-Substrats 202 durch Entfernern der Halbleiterschicht 210 bis zu dem Isolationsmaterial 220 des Basis-Substrats 202. Die Elektrodenstruktur für die Ionenfalle wird gebildet, indem der Schritt 140 des Rückdünnes bis zu der Metallisierungsanordnung 230 durchgeführt wird, oder indem eine strukturierte Oberflächenmetallisierung auf das Isolationsmaterial 220 des rückgedünnten Basis-Substrats 202 aufgebracht wird, oder wobei die Elektrodenstruktur 206 für die Ionenfalle durch die strukturierte Metallisierungsanordnung 230 gebildet wird (siehe auch Schritt 140 von Fig. 1). Fign. 6a und 6b zeigen Beispiele einer Elektrodenvorrichtung 200 mit rückgedünntem Basis-Substrat.

Das Verfahren umfasst in einem Schritt 320 ein Bereitstellen eines weiteren Substrats mit einer weiterer Elektrodenstruktur.

Das weitere Substrat kann eine Platten- oder Waferform aufweisen. Das Substrat kann umfassen oder bestehen aus einem dielektrisches Material, wie z.B. Glas, Diamant, Saphir, Korund oder Keramik. Das weitere Substrat kann ein Metall umfassen. Das weitere Substrat kann an zumindest einer Oberfläche eine Oberflächenbeschichtung umfassen, die ein dielektrisches Material aufweist. Die weitere Elektrodenstruktur kann auf dem dielektrisches Material oder der Oberflächenbeschichtung angeordnet sein. Das Bereitstellen des weiteren Substrats mit der weiteren Elektrodenstruktur kann ein Herstellen des weiteren Substrats mit der weiteren Elektrodenstruktur umfassen. Das Herstellen der weiteren Elektrodenstruktur kann zumindest eines umfassen aus optischer Lithographie, Grautonlithographie und Materialabscheidung. Das weitere Substrat kann mittels eines Verfahrens mit geringer Komplexität hergestellt werden. So kann beispielsweise das weitere Substrat durch ein Formen von metallischen Elektroden auf einem Glassubstrat hergestellt werden. Durch das weitere Substrat kann beispielsweise keine elektrische Leitung vorgesehen sein.

Das weitere Substrat kann jedoch auch eine komplexere Struktur aufweisen. Das Bereitstellen gemäß Schritt 320 kann beispielsweise ein Durchführen jedes hierin beschriebenen Verfahrens (100) zum Herstellen eines weiteren rückgedünnten Basis-Substrats mit einer Elektrodenstruktur, die die weitere Elektrodenstruktur bildet, umfassen.

In diesem Fall umfasst Schritt 320 ebenfalls die mit Bezug auf Schritt 310 genannten Schritte (des Verfahrens 100 ) des Bereitstellens und Verbindens des Basis-Substrat und des Isolationssubstrat sowie das Rückdünnen des Basis-Substrats. Ein weiteres Substrat, das ein weiteres rückgedünntes Basis-Substrat umfasst, kann eine elektrische Kontaktierung ermöglichen oder erleichtern, z. B. auf einer des rückgedünnten Basis-Substrats (oder auch einem Freiraum für Ionen) abgewandten Seite des weiteren rückgedünnten Basis-Substrats und/oder des weiteren Isolationssubstrats.

Das Bereitstellen gemäß Schritt 320 kann jedoch auch nur Teile und/oder Variationen des Verfahrens 100 umfassen. Beispielweise kann Schritt 320 ein Bereitstellen eines Basis-Substrats gemäß Schritt 110, aber ohne Schritte 120, 130 und 140 umfassen. Das weitere Substrat kann ohne Isolationssubstrat ausgebildet sein. In einem anderen Beispiel kann in einer Variation des Schritts 110 das Verfahren umfassen ein Bereitstellen eines Basis-Substrats, das auf einer Halbleiterschicht eine Metallisierungsanordnung auf (anstatt in) einem Isolationsmaterial aufweist.

Das Herstellen der Elektrodenstruktur kann jeden Verfahrensschritt wie hierin beschrieben in jeglicher Kombination aufweisen. Die Elektrodenstruktur kann jedes Merkmal wie hierin beschrieben in jeglicher Kombination aufweisen. Das Herstellen der weiteren Elektrodenstruktur kann jeden Verfahrensschritt wie hierin beschrieben in jeglicher Kombination aufweisen. Die weitere Elektrodenstruktur kann jedes Merkmal wie hierin beschrieben in jeglicher Kombination aufweisen.

Die Elektrodenstruktur und die weitere Elektrodenstruktur können (zumindest im Wesentlichen) identische Merkmale aufweisen oder durch identische Verfahrensschritte hergestellt werden. Die Elektrodenstruktur und die weitere Elektrodenstruktur können beispielsweise von derselben Herstellungsvorrichtung hergestellt werden oder parallel im selben Herstellungsprozess hergestellt werden.

Alternativ hierzu können die Elektrodenstruktur und die weitere Elektrodenstruktur durch verschiedene Herstellungsschritte hergestellt werden und/oder verschiedene Merkmale aufweisen.

Das Verfahren umfasst in einem Schritt 330 ein Verbinden des rückgedünnten Basis-Substrats und des weiteren Substrats (z. B. eines weiteren rückgedünnten Basis-Substrats) mittels einer dazwischen angeordneten Abstandshalterstruktur, so dass die Elektrodenstruktur und die weitere Elektrodenstruktur einander (vertikal) gegenüberliegen und die Elektrodenanordnung für die 3-dimensionale Ionenfalle bilden.

Ein Isolationsmaterial der Elektrodenvorrichtung und ein optionales weiteres Isolationsmaterial einer weiteren Elektrodenvorrichtung (z. B. des weiteren Substrats oder eines weiteren rückgedünnten Basis-Substrats) können einander zugewandt sein. Ein Isolationssubstrat der Elektrodenvorrichtung und ein optionales weiteres Isolationssubstrat der weiteren Elektrodenvorrichtung können voneinander abgewandt sein. Zumindest ein Teil der Elektrodenstruktur und der weiteren Elektrodenstruktur (z. B. ein Teil oder alle Elektroden und/oder Leiterbahnen der beiden Elektrodenstrukturen) kann spiegelsymmetrisch angeordnet sein, wobei eine Spiegelebene (z. B. senkrecht) durch die Abstandshalterstruktur verläuft. Wenn das weitere Substrat ein weiteres rückgedünntes Basis-Substrat umfasst kann zumindest ein Teil der beiden rückgedünnten Basis-Substrate (z. B. zumindest ein Teil der Elektrodenstrukturen, der Metallisierungsanordnungen, der Isolationsmaterialien, oder einer beliebigen Kombination davon) kann spiegelsymmetrisch angeordnet sein, wobei eine Spiegelebene (z. B. senkrecht) durch die Abstandshalterstruktur verläuft.

Fig. 9b zeigt einen schematischen Querschnitt eines Beispiels eines Elektrodensystems 400 mit einer Elektrodenanordnung 208 für eine 3-dimensionale Ionenfalle. Das Elektrodensystem 400 umfasst eine Abstandshalterstruktur 260 zwischen einer Elektrodenvorrichtung 200-1 und einer weiteren Elektrodenvorrichtung 200-2. Im Beispiel des Elektrodensystems 400, das in Fig. 9b gezeigt wird, wird das weitere Substrat durch die weitere Elektrodenvorrichtung 200-2 gebildet. Alternativ kann das Elektrodensystem 400 jedes andere hierein beschriebene weitere Substrat umfassen.

Die Elektrodenvorrichtung 200-1 umfasst ein Isolationssubstrat 250-1 und ein rückgedünntes Basis-Substrat 202-1 umfassend ein Isolationsmaterial 220-1, in dem eine Metallisierungsanordnung 230-1 angeordnet ist.

Die weitere Elektrodenvorrichtung 200-2 umfasst ein weiteres Isolationssubstrat 250-2 und ein weiteres rückgedünntes Basis-Substrat 202-2 umfassend ein weiteres Isolationsmaterial 220-2, in dem eine weitere Metallisierungsanordnung 230-2 angeordnet ist.

Die Abstandshalterstruktur 260 in Beispiel von Fig. 9b weist zwei Abstandselemente 262a, b auf. Alternativ kann die Abstandshalterstruktur 260 nur ein oder mehrere (z. B. drei, vier, fünf oder mehr) Abstandselemente 262 aufweisen. Die Abstandshalterstruktur 260 (oder ein Abstandselement davon) kann eine oder mehrere (durchgängige) Öffnungen aufweisen. Die Öffnung kann ausgebildet sein, (z. B. zusammen mit der Elektrodenstruktur 206-1 und der weiteren Elektrodenstruktur 206-2) ein Volumen für eine 3D-Ionenfallen (zumindest teilweise) zu begrenzen. Die Abstandshalterstruktur 260 kann beispielsweise eine Plattenstruktur mit einer oder mehreren durchgängigen Öffnungen umfassen, die jeweils zwischen Elektrodenstrukturen 206-1, 206-2 und weiteren Elektrodenvorrichtungen 200-1, 200-2 angeordnet sind.

Die Abstandshalterstruktur 260 kann ein dielektrisches Material, wie z.B. Glas, Diamant, Saphir, Korund oder Keramik, aufweisen.

Bei dem Schritt des Verbindens des rückgedünnten Basis-Substrats 202-1 und des weiteren rückgedünnten Basis-Substrats 202-2 kann die Abstandshalterstruktur 260 als ein Abstandssubstrat (z. B. mit einer plattenförmigen Struktur) ausgebildet sein und zwischen dem rückgedünnten Basis-Substrat 202-1 und dem weiteren rückgedünnten Basis-Substrat 202-2 angeordnet sein.

Das Abstandssubstrat kann ein dielektrisches Material, wie z.B. Glas, Diamant, Saphir, Korund oder Keramik, aufweisen. Das Abstandssubstrat kann eine Metallbeschichtung auf zumindest einer lateralen Seite (die beispielsweise auf ein Volumen gerichtet ist, in dem ein Ion gehalten werden soll) eine Metallbeschichtung aufweisen. Die Metallbeschichtung kann mit einem Massepotential oder einem Bezugspotential elektrisch verbunden sein. Die Metallbeschichtung kann beispielsweise mit einem Teil aus zumindest einem aus der der Elektrodenanordnung 208, der Elektrodenstruktur 206-1 und der weiteren Elektrodenstruktur 206-2 (z. B. ein, zwei oder mehr Elektroden) elektrisch verbunden sein, der wiederum elektrisch mit einem Massepotential oder einem Bezugspotential elektrische verbunden sein kann. Ein anderer (oder restlicher) Teil der Elektrodenstruktur 208 kann beispielsweise eine ansteuerbare Elektrodenanordnung für eine 3D-Ionenfalle bilden. Alternativ kann die gesamte Elektrodenanordnung 208 eine ansteuerbare Elektrodenanordnung für eine 3D-Ionenfalle bilden.

Die Abstandshalterstruktur (oder ein Teil davon) kann auf dem Isolationsmaterial 220-1 oder 220-2) durch Materialabscheidung geformt sein.

Das Basis-Substrat 202-1 kann während der Schritte des Verbindens mit dem Isolationssubstrat 250-1, des Rückdünnens des Basis-Substrats 202-1 und des Verbindens mit dem weiteren Substrat (z. B. mit dem weiteren rückgedünnten Basis-Substrat 202-2) auf einem Trägersubstrat, z.B. aus einem dielektrisches Material, wie Glas, Diamant, Saphir, Korund oder Keramik, fixiert sein. Das Trägersubstrat erleichtert die Handhabung und ermöglicht das gleichzeitige Prozessieren einer Vielzahl von (Basis-)Substraten 202-1, 202-2.

Die Elektrodenanordnung 208 umfasst die Elektrodenstrukturen 206-1, 206-2 und erlaubt das Erzeugen von elektrischen Felder, die beispielsweise zum Steuern einer Position eines Ions 280 verwendet werden können. Die Elektrodenanordnung 208 kann mit einem gemeinsamen Signal angesteuert werden. Alternativ hierzu können die Elektrodenstrukturen 206-1, 206-2 mit verschiedenen Signalen angesteuert werden. Einzelne Elektroden derselben Elektrodenstruktur 206-1, 206-2 können mit verschiedenen Signalen angesteuert werden. Dabei können optional Elektroden verschiedener Elektrodenstrukturen 206-1, 206-2 mit demselben Signal angesteuert werden (z. B. zur Erzeugung einer Quadrupolfeldverteilung).

Das Beispiel des Elektrodensystems 400, das in Fig. 9b dargestellt ist, sind die Elektrodenvorrichtungen 200-1, 200-2, die rückgedünnten Basis-Substrate 202-1, 202-1, die Metallisierungsanordnungen 230-1, 230-2 und die Elektrodenstrukturen 206-1, 206-2 spiegelsymmetrisch bezüglich einer Spiegelebene durch die Abstandshalterstruktur 260 (parallel zu den x- und y-Achsen) angeordnet. Alternativ dazu kann sich die Spiegelsymmetrie auf eine jede mögliche Kombination der oben genannten Komponenten erstrecken.

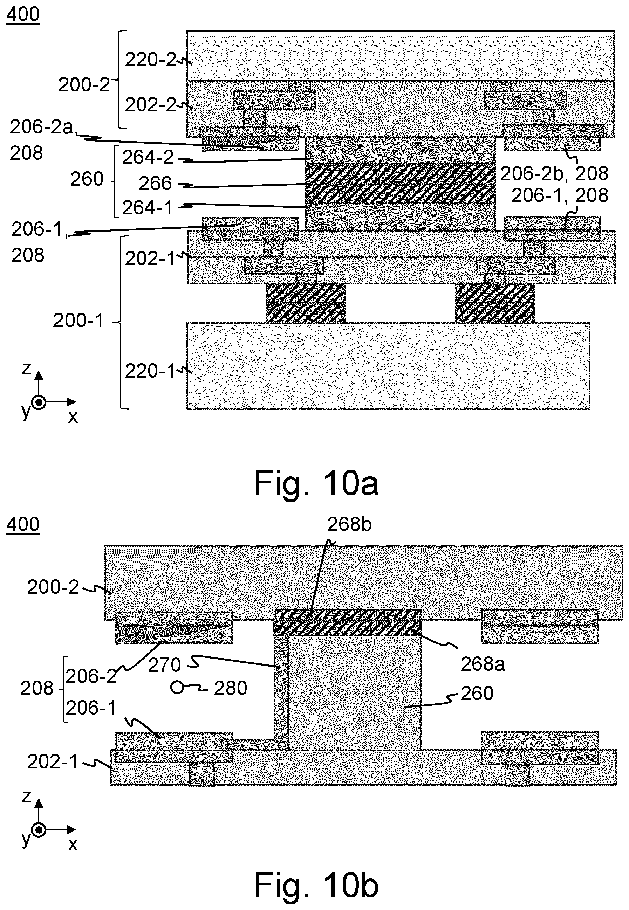

Fig. 10a zeigt einen schematischen Querschnitt eines weiteren Beispiels eines Elektrodensystems 400 mit einer Elektrodenanordnung 208 für eine 3-dimensionale Ionenfalle.

Das Verfahren zur Herstellung der Elektrodenanordnung 208 kann ferner umfassen ein Anordnen einer Interconnect-Struktur 264-1 an dem rückgedünnten Basis-Substrat 202-1 (z. B. an dem Isolationsmaterial 220-1) und einer weiteren Interconnect-Struktur 264-2 an dem weiteren Substrat (z. B. einem weiteren rückgedünnten Basis-Substrat 202-2 (z. B. an dem Isolationsmaterial 220-1)). Das Anordnen der Interconnect-Strukturen 264-1, 264-2 kann mittels Materialabscheidung oder eines Oxid/Oxid-Bondvorgangs auf dem jeweilige Isolationsmaterial 220-1, 220-2 erfolgen. Im Beispiel des Elektrodensystems 400, das in Fig. 10a gezeigt wird, wird das weitere Substrat durch die weitere Elektrodenvorrichtung 200-2 gebildet. Alternativ kann das Elektrodensystem 400 jedes andere hierein beschriebene weitere Substrat umfassen.

Das Verfahren kann ferner umfassen ein Verbinden des rückgedünnten Basis-Substrats 202-1 und des weiteren Substrats (z. B. des weiteren rückgedünnten Basis-Substrats 202-2) durch Verbinden der gegenüberliegenden Interconnect-Strukturen 264-1, 264-2, wobei die verbundenen Interconnect-Strukturen 264-1, 264-2 die Abstandshalterstruktur 260 (zumindest zum Teil) bilden.

Die gegenüberliegenden Interconnect-Strukturen 264-1, 264-2 ermöglichen eine mechanische und/oder elektrische Verbindung zwischen den (Basis-)Substraten 202-1, 202-2. Im Falle einer elektrischen Verbindung kann eine Anordnung von elektrischen Leitungen des Elektrodensystems 400 vereinfacht werden. So kann beispielsweise eine elektrische Leitung von einer Elektrodenstruktur 206-1 über die Abstandshalterstruktur 260 auf die Seite der Elektrodenstruktur 206-2 zu einer leichteren Bündelung von elektrischen Leitern geführt werden.

Eine derartige Anordnung erlaubt beispielsweise ein Anlegen von elektrischen Signalen an nur einer Seite des Elektrodensystems 400 (z. B. für eine einseitige Ansteuerung). Beispielsweise kann ein Teil der elektrischen Signale an einen Teil der Metallisierungsanordnung 230 angelegt werden, der elektrisch mit der Elektrodenanordnung 206-1 verbunden ist, und ein weiterer Teil der elektrischen Signale an einem weiteren Teil der der Metallisierungsanordnung 230 angelegt werden, der mit der elektrisch mit der weiteren Elektrodenanordnung 206-2 verbunden ist. Ferner kann die Metallisierungsanordnung 230 weitere Teile umfassen, die mit anderen Komponenten verbunden sind (z. B. eine oder mehrere Metallisierungen, die beispielsweise über die Metallisierungsanordnung 230 mit einem Massepotential oder einem Bezugspotential elektrisch verbunden sind). Eine elektrische Leitung über die Abstandshalterstruktur 260 kann somit eine flexiblere und/oder leichtere elektrische Verbindung und Ansteuerung ermöglichen. Ferner können Anforderungen an das weitere Substrat verringert werden, da beispielsweise auf eine elektrische Verbindung durch ein optionales weiteres rückgedünntes Basis-Substrat 202-2 und/oder durch ein optionales weiteres Isolationssubstrat 250-2 verzichtet werden kann.

Das weitere Substrat kann beispielsweise auf dessen Oberfläche eine weitere Elektrodenstruktur aufweisen, die mit einer elektrischen Leitung an der Abstandshalterstruktur 260 verbunden ist. Eine elektrischen Leitung an der Abstandshalterstruktur 260 ist jedoch für ein weitere Substrat mit geringer Komplexität (z. B. ohne ein weiteres rückgedünntes Basis-Substrat) nicht erforderlich. Die weitere Elektrodenstruktur kann auch über andere elektrische Leitungen angesteuert werden. Weitere elektrische Leitungen können beispielweise entlang einer Oberfläche des weiteren Substrats aus einen Freiraum für die 3D-Ionenfalle geführt werden. Ferner kann das Substrat Metall umfassen (z. B. lokal begrenzt und/oder zumindest teilweise durch eine elektrisch isolierende Schicht von der weiteren Elektrodenstruktur getrennt), das eine elektrische Leitung zur Ansteuerung ermöglichen kann.

Das Verbinden der gegenüberliegenden Interconnect-Strukturen 264-1, 264-2 kann mittels eines Bondvorgangs, wie z. B. eines Oxid/Oxid-Bondvorgangs oder eines Metall-Bondvorgangs erfolgen. Vor dem Verbinden der gegenüberliegenden Interconnect-Strukturen 264-1, 264-2 kann auf zumindest eine der Interconnect-Strukturen 264-1, 264-2 eine Metallisierung aufgebracht werden. Im Beispiel, das in Fig. 10a gezeigt wird, sind die Interconnect-Strukturen 264-1, 264-2 mittels einer Metallverbindung 266 (z.B. zum Bereitstellen einer oder mehrerer Leiterbahnen) verbunden.

Bei dem Schritt des Verbindens des rückgedünnten Basis-Substrats 202-1 und des weiteren Substrats (z. B. des weiteren rückgedünnten Basis-Substrats 202-1) können (zumindest) zwei lateral benachbarte Elektrodenstrukturen 206-1 des rückgedünnten Basis-Substrats 202-1 vertikal gegenüberliegend zu zwei lateral benachbarten Elektrodenstrukturen 206-2a, 206-2b des weiteren Substrats (z. B. des weiteren rückgedünnten Basis-Substrats 202-2) angeordnet werden. Dadurch können bei Anlegen elektrischer Signale an die Elektrodenstrukturen 206-1, 206-2a, 206-2b verschiedene elektrische Felder erzeugt werden. Die Elektrodenstrukturen 206-1, 206-2 können zumindest im Wesentlichen identische Dimensionen aufweisen (z. B. eine Spiegelsymmetrie aufweisen). Die vertikal gegenüberliegende Anordnung kann eine Symmetrie dieser elektrischen Felder verbessern.

Die zwei vertikal gegenüberliegenden Paare der Elektrodenstrukturen können die ansteuerbare Elektrodenanordnung der 3D-Ionenfalle (z. B. für Quantencomputeranwendungen) bilden. Da die Paare der Elektrodenstrukturen sich gegenüberliegen, können leichter elektrische Felder erzeugt werden, die ein Ion in einem dreidimensionalen Volumen zwischen den Elektrodenstrukturen halten können.

Das Verfahren kann ferner umfassen ein Strukturieren der Elektrodenstruktur 206-1, 206-2a, 206-2b des rückgedünnten Basis-Substrats 202-1 und/oder des weiteren Substrats (z. B. des weiteren rückgedünnten Basis-Substrats 202-2), z.B. mittels Grautonlithographie, um eine dreidimensional strukturierte Elektrodenstruktur 206-1, 206-2a, 206-2b der Elektrodenanordnung 208 zu erhalten. Die Grautonlithographie kann ein Bewegen einer Lichtmaske bei einer Beleuchtung und/oder die Verwendung einer Lichtmaske mit einem variierendem Grad an Lichttransmission umfassen.

Im Beispiel, das in Fig. 10a gezeigt wird, ist die Elektrodenstruktur 206-2a strukturiert worden um eine dreidimensional strukturierte Elektrodenstruktur 206-2a zu erhalten. Alternativ können mehrere oder alle Elektrodenstrukturen 206-1, 206-2a, 206-2b als dreidimensional strukturierte Elektrodenstrukturen 206-1, 206-2a, 206-2b ausgebildet werden. Dreidimensionale Elektrodenstrukturen können eine Flexibilität bei einer Formgebung und Optimierung elektrischer Felder verbessern. Dadurch kann die Steuerung eines Ions in der dreidimensionalen Ionenfalle verbessert werden.

Fig. 10b zeigt einen schematischen Querschnitt eines weiteren Beispiels eines Elektrodensystems 400 für eine 3-dimensionale Ionenfalle.

Das Elektrodensystem 400 umfasst eine Elektrodenanordnung 208 mit Elektrodenstrukturen 206-1, 206-2, welche elektrischer Felder erzeugen können, die es erlauben, eine Position eines Ions in der 3-dimensionalen Ionenfalle zu steuern.

Ein rückgedünntes Basis-Substrat 202-1 (nur schematisch in Fig. 10b dargestellt) ist mit einer Abstandshalterstruktur 260 verbunden, die eine Metallisierung 268a aufweist. Die Metallisierung 268a ist mittels einer Metallverbindung 270 (z. B. eine Leiterbahn, z. B. eine metallische Leiterbahn) elektrisch mit einer Elektrodenstruktur 206-1 der des Basis-Substrats 202-1 verbunden. Ein weiteres Substrat 200-2 weist eine weitere Metallisierung 268b auf.

Das Verbinden des rückgedünnten Basis-Substrats 202-1 und eines weiteren Substrats 200-2 (nur schematisch in Fig. 10b dargestellt) kann mittels eines Metall-Bondvorgangs zwischen der Metallisierung 268a und der weiteren Metallisierung 268b erfolgen. Die Elektrodenstruktur 206-1 weist folglich über die Metallverbindung 270 und den Metallisierungen 268a, b eine elektrische Verbindung zum weiteren Substrat 200-2 auf. Daher können elektrische Verbindungen für das Elektrodensystems 400 auf der Seite des weiteren Basis-Substrats 202-2 gebündelt werden (z. B. zum Ansteuern der Elektroden 206-1, 206-2 mit demselben Signal). Optional kann die Metallverbindung 270 in Form einer Elektrodenerweiterung der Elektrodenstruktur 206-1 ausbildet sein. Der oben mit Bezug auf Fig. 10a beschriebene elektrische Leiter ist eine Beispiel der Metallverbindung 270. Daher kann die Metallverbindung 270 ausgestaltet und verwendet werden wie der oben beschriebene elektrische Leiter. Folglich gelten die oben für den elektrischen Leiter offenbarten Vorteile auch für die Metallverbindung 270. Aufgrund der Metallverbindung 270 können eine oder mehrere (oder alle) Elektroden der weiteren Elektrodenstrukturen 270 über die Elektrodenstruktur der rückgedünnten Basis-Substrats 202-1 angesteuert werden (z. B. für eine einseitige Ansteuerung). Das Elektrodensystem 400 kann über eine oder mehrere Metallverbindungen 270 ausgelegt sein, von nur einer Seite angesteuert zu werden. Das weitere Substrat 200-2 kann beispielsweise ohne elektrische Leitungen durch das weitere Substrat 200-2 vorgesehen sein (wie schematisch in Fig. 10b dargestellt).

Die Metallverbindung 270 (und/oder die mit Bezug auf Fig. 10a beschriebene Ausgestaltung in Form der elektrischen Leitung über die Abstandshalterstruktur 260) kann auch mit einem weiteren rückgedünnten Basis-Substrat 202-2 kombiniert werden. Dadurch kann ein Ansteuern der Elektrodenanordnung 208 flexibler gestaltet werden. Beispielsweise können über Metallisierungsanordnungen beider rückgedünnten Basis-Substrate 202-1, 202-2 Elektroden zur Erzeugung elektrischer Felder für die 3D-Ionenfalle verwendet werden. Das Elektrodensystem 400 kann ausgebildet sein, von zwei Seiten angesteuert (z. B. für eine zweiseitige oder beidseitige Ansteuerung) zu werden (z. B. mittels des rückgedünnten Substrats 202-1 von einer ersten Seite und mittels des weiteren rückgedünnten Substrats 202-2 von einer zweiten Seite). Ferner kann eine Elektrode (oder mehrere Elektroden) des rückgedünnten Basis-Substrats 202-1 (und/oder des weiteren rückgedünnten Basis-Substrats 202-2) über die Metallverbindung 270 (und/oder über die elektrische Leitung über der Abstandshalterstruktur 260) mit Metallisierungsflächen beider rückgedünnten Basis-Substrate 202-1, 202-2 verbunden sein. Die Metallisierungsflächen können dann beispielweise gemeinsam mit einem Massepotential oder einem Bezugspotential elektrisch verbunden sein.

Fig. 10b zeigt beispielhaft nur eine Metallverbindung (z.B. eine oder mehrere Leiterbahnen) 270. Die Metallverbindung 270 kann mit einer, mehreren oder allen Elektroden der weiteren Elektrodenstruktur 206-2 elektrisch verbunden sein (beispielweise zum Anlegen eines gemeinsamen elektrischen Signals). Zu diesem Zweck können entlang einer Oberfläche des weiteren Substrats elektrische Verbindungen (in Fig. 10b nicht dargestellt) zwischen der weitere Metallisierung 268b und Elektroden der weiteren Elektrodenstruktur 206-2 vorgesehen sein. Alternativ kann das Elektrodensystem 400 mehr als eine Metallverbindung 270 (z. B. an derselben Abstandshalterstruktur 260 und/oder an verschiedenen Abstandshalterstrukturen 260) aufweisen. Ferner kann das Elektrodensystem 400 mehr als eine Metallisierung 268a und mehr als eine weitere Metallisierung 268b) aufweisen. Eine Vielzahl von Metallverbindung 270 können individuelle elektrische Verbindungen zu Elektroden der weiteren Elektrodenstruktur 206-2 ermöglichen. In derselben Weise kann das Elektrodensystem eine Vielzahl von elektrischen Leitungen über die Abstandshalterstruktur 260 aufweisen.

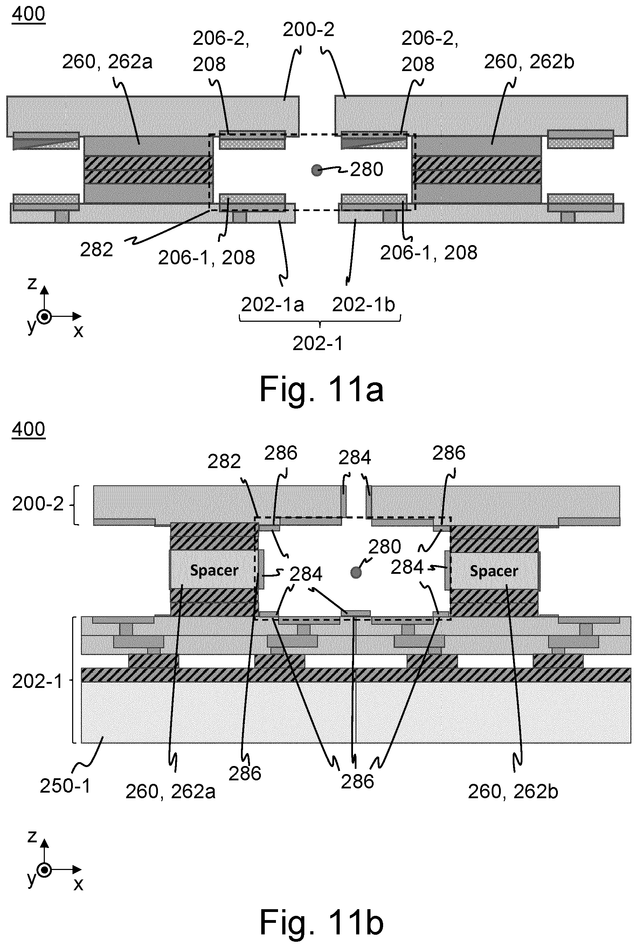

Fig. 11a zeigt einen schematischen Querschnitt eines weiteren Beispiels eines Elektrodensystems 400 für eine 3-dimensionale Ionenfalle.

Das Elektrodensystem 400 umfasst ein rückgedünnten Basis-Substrat 202-1 (nur schematisch in Fig. 11a dargestellt) und ein weiteres Substrat 200-2 (nur schematisch in Fig. 11a dargestellt). Das Basis-Substrat 202-1 umfasst eine Elektrodenstruktur 206-1 und das weitere Substrat 200-2 umfasst eine weitere Elektrodenstruktur 206-2, wobei die Elektrodenstrukturen 206-1, 206-2 Teil einer Elektrodenanordnung 208 sind. In Fig. 11a weist das rückgedünnte Basis-Substrat 202-1 zwar ein Isolationssubstrat auf, welches jedoch in der Fig. 11a nicht dargestellt werden. Das weitere Substrat 200-2 kann jedes hierein beschriebene Substrat 200-2 sein (z. B. umfassend ein Dielektrikum mit einer weiteren Elektrodenstruktur oder umfassend ein weiteres rückgedünntes Basis-Substrat).

Die Elektrodenanordnung 208 kann verwendet werden um eine Position eines Ions 280 zwischen den Elektrodenstrukturen 206-1, 206-2 zu steuern. Die weitere Elektrodenstruktur 206-2 weist beispielhaft eine Elektrode mit einer dreidimensional strukturierte Elektrodenstruktur auf. Alternativ können keine, mehrere oder alle Elektroden der Elektrodenstrukturen 206-1, 206-2 eine dreidimensional strukturierte Elektrodenstruktur aufweisen.

Das rückgedünnte Basis-Substrat 202-1 (und/oder das weitere Substrat 200-2) kann mehrere Basis-Substratteile 202-1a, 202-1 umfassen. Die Basis-Substratteile 202-1a, 202-1 können jeweils eine Elektrodenstruktur 206-1 aufweisen, die Teil der Elektrodenanordnung 208 ist.

Wie beispielhaft in Fig. 11a gezeigt, kann bei dem Schritt des Verbindens des rückgedünnten Basis-Substrats 202-1 und des gegenüberliegenden, weiteren Substrats 200-2 zwischen benachbarten Abstandshalterstrukturen 262a, b ein Freiraum 282 gebildet werden.

Das Verfahren kann ferner umfassen ein Anordnen einer Metallisierungsfläche bereichsweise oder vollständig an nicht-metallischen Seitenwandbereichen des Freiraums 282.

Fig. 11b zeigt einen schematischen Querschnitt eines weiteren Beispiels eines Elektrodensystems 400 für eine 3-dimensionale Ionenfalle mit einer Metallisierungsfläche 284 auf nicht-metallischen Seitenwandbereichen.

Das Elektrodensystem 400 umfasst ein rückgedünntes Basis-Substrat 202-1 und ein weiteres Substrat 200-2, zwischen denen Abstandshalterstrukturen 262a, b angeordnet sind. Das weitere Substrat 200-2 kann als jedes hierin beschriebene weitere Substrat (z. B. umfassend ein weiteres rückgedünntes Basis-Substrat 202-2) implementiert werden.

Wie beispielhaft in Fig. 11b gezeigt, kann bei dem Schritt des Verbindens des rückgedünnten Basis-Substrats 202-1 und des gegenüberliegenden, weiteren Substrats 200-2 zwischen benachbarten Abstandshalterstrukturen 262a, b (z. B. Spacer) ein Freiraum 282 gebildet werden.

Der Freiraum 282 weist (zumindest vor dem Anordnen einer Metallisierungsfläche) nicht-metallischen Seitenwandbereiche 286 auf, wie beispielsweise an Oberflächen eines Isolationsmaterials der (Basis)-Substrate 202-1, 200-2 und Oberflächen von Abstandshalterstrukturen 262a, b. Fig. 11b zeigt Metallisierungsflächen 284, die bereichsweise oder vollständig an den nicht-metallischen Seitenwandbereichen 286 des Freiraums 282 angeordnet sind.

Die Metallisierungsflächen 284 können eine Abschirmung des Freiraums 282 und somit einer Steuerung von elektrischen Feldern im Freiraum 282 verbessern. Mehrere oder alle Metallisierungsflächen 284 können mit einem Massepotential oder einem Bezugspotential elektrisch verbunden sein. Die mehreren oder alle Metallisierungsflächen 284 können über eine oder mehrere Elektroden der Elektrodenvorrichtungen 208 (und optional über eine oder mehrere in Fig. 11b nicht dargestellte Metallverbindungen wie Metallverbindung 270 in Fig. 10b) mit dem Massepotential oder dem Bezugspotential elektrisch verbunden sein.

Wie in den Fign. 10a bis 11b angedeutet ist, können die Elektrodensysteme 400, jenseits der Abstandshalterstruktur 260 weitere Elektrodenstrukturen aufweisen, die Teil einer weiteren Elektrodenvorrichtung sein können. Ein Elektrodensystem 400 kann folglich eine Vielzahl von Elektrodenvorrichtungen 208 aufweisen, die jeweils durch Abstandshalterstruktur 260 voneinander getrennt sind.

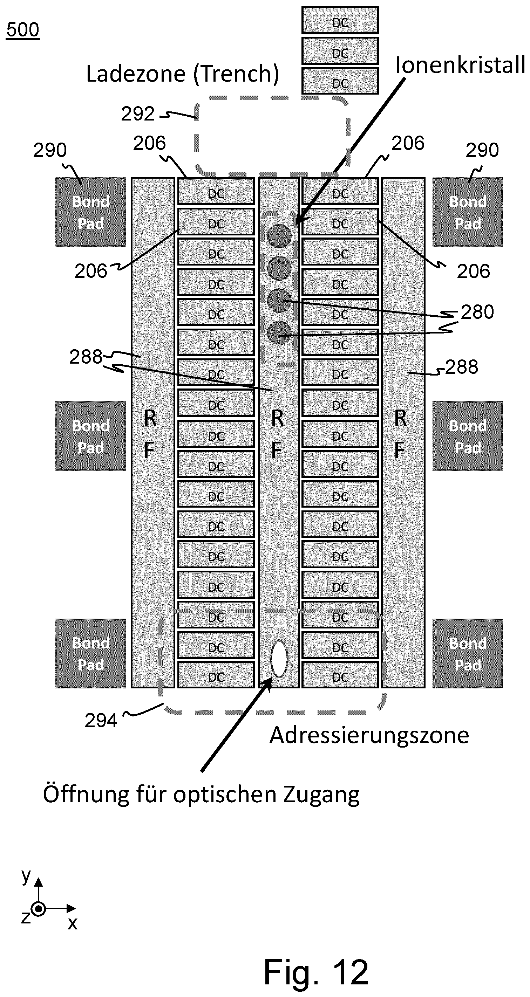

Fig. 12 zeigt eine schematische Aufsicht auf ein Beispiel einer Ionenfalle 500 mit einer Elektrodenvorrichtung. Die Ionenfalle 500 kann mittels eines hierin beschriebenen Verfahrens hergestellt werden (oder mittels eines Verfahrens, das ein hierin beschriebene Herstellungsverfahren umfasst). Die Ionenfalle 500 kann beispielsweise eine dimensionale Paul-Ionenfallen-Anordnung aufweisen. Eine derartige Anordnung kann eine bessere elektrische Feldverteilung bieten als Oberflächenfallen.

Jede hierin beschriebene Elektrodenvorrichtung 400 und/oder Elektrodenstruktur 206 kann in der Ionenfalle implementiert werden.

Die Ionenfalle 500 weist eine Vielzahl von Elektrodenstrukturen 206 auf (von denen in Fig. 12 der Übersichtlicht halber nur die obersten vier Elektrodenstrukturen 206 mit einem Bezugszeichen versehen sind), die in einer Reihe angeordnet sind. Die in Fig. 12 dargestellten Elektrodenstruktur 206 können beispielsweise Elektrodenstrukturen 206 eines weiteren Substrats 200-2 (z. B. umfassend ein weiteres rückgedünntes Basis-Substrat 202-2) sein. Die Elektrodenstrukturen 206 werden mit einer Gleichspannung (DC) betrieben. Ferner weist die Ionenfalle entlang der Reihe von Elektrodenstrukturen 206 drei gemeinsame Längselektroden 288 auf, welche mit einer Wechselspannung (RF) bestrieben werden. Die Ionenfalle 400 weist Bond-Pads 290 auf, welche beispielweise elektrisch mit den Elektrodenstrukturen 206 und die Längselektroden 288 verbunden sind.

Die Elektrodenstrukturen 206 und die Längselektroden 288 erzeugen durch die jeweils anliegenden Gleich- und Wechselspannungen elektrische Felder, die es ermöglichen, Positionen von Ionen in der Ionenfalle zu steuern. So werden beispielsweise in Fig. 12 vier Ionen 280 in einer Reihe angeordnet, um gemeinsam einen Ionenkristall zu bilden.

Die Elektrodenstrukturen 206 und die Längselektroden 288 erlauben auch eine Bewegung der Ionen 280 entlang der Längselektroden 288 zu steuern. So können mittels der Elektrodenstrukturen 206 und die Längselektroden 288 elektrische Felder erzeugt werden, um Ionen aus einer Lade-Zone 292 in einen Freiraum zwischen den Elektrodenstrukturen 206 und/oder zu einer Adressierzone 294 zu bewegen. Die Adressierzone 294 weist einen optischen Zugang auf, um beispielweise Ionen 280 optisch zu manipulieren (z. B. Anzuregen und eine Kopplung zwischen Ionen 280 zu induzieren).

Die Vielzahl von Elektrodenstrukturen 206 können mit dem hierin beschriebenen Verfahren präzise hergestellt werden, wobei rückgedünnte Basis-Substrate verringerte parasitäre Kapazitäten aufweisen. Daher kann die Kohärenzzeit von Ionenzustände verlängert werden.

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der Verfahrensschritte durch einen solchen Apparat ausgeführt werden. Je nach bestimmten Implementierungsanforderungen können Ausführungsbeispiele der Erfindung in Hardware oder in Software oder zumindest teilweise in Hardware oder zumindest teilweise in Software implementiert sein.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind.

Solche Kombinationen seien umfasst, es sei denn es ist ausgeführt, dass eine spezifische Kombination nicht beabsichtigt ist. Ferner ist beabsichtigt, dass auch eine Kombination von Merkmalen eines Anspruchs mit jedem anderen unabhängigen Anspruch umfasst ist, selbst wenn dieser Anspruch nicht direkt abhängig von dem unabhängigen Anspruch ist.

Obwohl spezifische Ausführungsbeispiele hierin dargestellt und beschrieben wurden, wird einem Fachmann offensichtlich sein, dass eine Vielzahl von alternativen und/oder äquivalenten Implementierungen für die spezifischen dort gezeigten und dargestellten Ausführungsbeispiele ersetzt werden können, ohne von dem Gegenstand der folgenden Ansprüche abzuweichen. Daher wird die vorliegende Erfindung durch den Wortlaut der Ansprüche begrenzt.

## Patentansprüche

1. Verfahren (100) zur Herstellung einer Elektrodenstruktur (206) für eine Ionenfalle, mit folgenden Schritten:
Bereitstellen (110) eines Basis-Substrats (202), das auf einer Halbleiterschicht (210) eine in einem Isolationsmaterial (220) angeordnete strukturierte Metallisierungsanordnung (230) aufweist,
Bereitstellen (120) eines Isolationssubstrats (250), das ein dielektrisches Material (252) aufweist,
Verbinden (130) eines an dem Isolationsmaterial (220) angeordneten Oberflächenbereichs (224) des Basis-Substrats (202) mit dem Isolationssubstrat (250) mittels eines Bond-Vorgangs, und
Rückdünnen (140) des Basis-Substrats (202) durch Entfernern der Halbleiterschicht (210) bis zu dem Isolationsmaterial (220) des Basis-Substrats (202),
wobei die Elektrodenstruktur (206) für die Ionenfalle gebildet wird, indem der Schritt des Rückdünnes bis zu der Metallisierungsanordnung (230) durchgeführt wird, oder indem eine strukturierte Oberflächenmetallisierung (240) auf das Isolationsmaterial (220) des rückgedünnten Basis-Substrats (202) aufgebracht wird,
**oder**
wobei die Elektrodenstruktur (206) für die Ionenfalle durch die strukturierte Metallisierungsanordnung (230) gebildet wird.

2. Verfahren (100) nach Anspruch 1, wobei die Metallisierungsanordnung (230) als eine Mehrlagenmetallisierungsanordnung ausgebildet ist, wobei die Elektrodenstruktur (206) für die Ionenfalle gebildet wird, indem der Schritt des Rückdünnes bis zu einer obersten, strukturierten Metallisierungsschicht (232a) der Mehrlagenmetallisierungsanordnung durchgeführt wird.

3. Verfahren (100) nach Anspruch 1 oder 2, ferner mit folgendem Schritt:
Durchführen des Bond-Vorgangs zwischen dem Isolationsmaterial (220) des Basis-Substrats (202) und dem Isolationssubstrat (250) mittels eines Oxid/Oxid-Bondvorgangs.

4. Verfahren (100) nach einem der vorhergehenden Ansprüche, wobei der an dem Isolationsmaterial (250) angeordnete Oberflächenbereich (224) des Basis-Substrats (202), und das Isolationssubstrat (250) jeweils zugeordnete Metallanschlussflächen (238a, b, 254) aufweisen, ferner mit folgendem Schritt:
Durchführen des Bondvorgangs zwischen dem Basis-Substrat (202) und dem Isolationssubstrat (250) an den zugeordneten Metallanschlussflächen (238a, b, 254) mittels eines Metall-Bondvorgangs.

5. Verfahren (100) nach einem der vorhergehenden Ansprüche, wobei der Bond-Vorgang als Kombination (Hybrid-Bondvorgang) eines Oxid/Oxid-Bondvorgangs und eines Metall-Bondvorgangs durchgeführt wird.

6. Verfahren (100) nach einem der vorhergehenden Ansprüche, wobei die freigelegte Metallisierungsschicht (232a) der Metallisierungsanordnung (230) **oder** die aufgebrachte, strukturierte Oberflächenmetallisierung (240) auf dem Isolationsmaterial (220) des rückgedünnten Basis-Substrats (202) die Elektrodenstruktur (206) für die Oberflächen-Ionenfalle bildet.

7. Verfahren (100) nach einem der vorhergehenden Ansprüche, ferner mit folgendem Schritt:
Ausbilden einer Ausnehmung (228) in Form eines Lochs oder Grabens in dem Basis-Substrat (202) durch das Isolationsmaterial (220) der Metallisierungsanordnung zu der Halbleiterschicht (210).

8. Verfahren (100) nach Anspruch 7, wobei der Schritt des Ausbildens einer Ausnehmung (228) mittels einer Loch- oder Grabenätzung durchgeführt wird.

9. Verfahren (100) nach Anspruch 7 oder 8, ferner mit folgendem Schritt:
Anordnen einer Metallisierung (246) bereichsweise oder vollständig an Seitenwänden (248) der Ausnehmung (228) in dem Isolationsmaterial (220) des rückgedünnten Basis-Substrats (202).

10. Verfahren (100) nach einem der vorhergehenden Ansprüche, wobei bei dem Schritt des Rückdünnens des Basis-Substrats (202) die Halbleiterschicht (210) des Basis-Substrats (202) vollständig entfernt wird.

11. Verfahren (100) nach einem der vorhergehenden Ansprüche, wobei die in dem Isolationsmaterial (220) eingebettete Metallisierungsanordnung (230) als Antennenstruktur zum Bereitstellen elektrischen Felder für die Ionenfalle ausgebildet sind.

12. Verfahren (100) nach einem der vorhergehenden Ansprüche, wobei das Basis-Substrat (202) als ein Standard-Substrat aus der Halbleiterfertigung oder als ein IC-Substrat ausgebildet ist.

13. Verfahren (100) nach einem der vorhergehenden Ansprüche, wobei das dielektrische Material des Isolationssubstrats (250) Glas, Diamant, Saphir, Korund oder Keramik aufweist.

14. Verfahren (100) nach einem der vorhergehenden Ansprüche, wobei das Isolationsmaterial (220) des Basis-Substrats (202) ein Dielektrikum aus der Halbleiterfertigung, wie z.B. SiO₂ oder HfO₂, aufweist.

15. Verfahren (100) nach einem der vorhergehenden Ansprüche, wobei das Verfahren zur Herstellung einer Elektrodenstruktur (206) für eine Ionenfalle mittels Standard-Halbleiterfertigungsprozessschritten durchgeführt wird.

16. Verfahren (100) nach einem der vorhergehenden Ansprüche, wobei die Ionenfalle für Quantencomputeranwendungen vorgesehen ist.

17. Verfahren (300) zur Herstellung einer Elektrodenanordnung (208) für eine 3-dimensionale Ionenfalle, mit folgenden Schritten:
Durchführen des Verfahrens (100) nach einem der vorhergehenden Ansprüche, um eine Elektrodenstruktur (206-1) an einem rückgedünnten Basis-Substrat (202-1) herzustellen,
Bereitstellen eines weiteren Substrats (200-2) mit einer weiteren Elektrodenstruktur (206-2),
Verbinden des rückgedünnten Basis-Substrats (202-1) und des weiteren Substrats (200-2) mittels einer dazwischen angeordneten Abstandshalterstruktur (260), so dass die Elektrodenstruktur (206-1) und die weitere Elektrodenstruktur (206-2) einander gegenüberliegen und die Elektrodenanordnung (208) für die 3-dimensionale Ionenfalle bilden.

18. Verfahren (300) nach Anspruch 17, wobei das Bereitstellen des weiteren Substrats (200-2) ein Durchführen des Verfahrens (100) nach einem der Ansprüche 1 bis 16 zum Herstellen eines weiteren rückgedünnten Basis-Substrat (202-2) mit einer Elektrodenstruktur, die die weitere Elektrodenstruktur (206-2) bildet, umfasst, wobei das Verbinden des rückgedünnten Basis-Substrats (202-1) und des weiteren Substrats (200-2) an dem weiteren rückgedünnten Basis-Substrat (202-2) erfolgt.

19. Verfahren (300) nach Anspruch 17 oder 18, wobei bei dem Schritt des Verbindens des rückgedünnten Basis-Substrats (202-1) und des weiteren Substrats (200-2) zwei lateral benachbarte Elektrodenstrukturen (206-1) des rückgedünnten Basis-Substrats (202-1) vertikal gegenüberliegend zu zwei lateral benachbarten Elektrodenstrukturen (206-2) des weiteren Substrats (200-2) angeordnet werden.

20. Verfahren (300) nach Anspruch 19, wobei die zwei vertikal gegenüberliegenden Paare der Elektrodenstrukturen (206-1, 206-2) die ansteuerbare Elektrodenanordnung (208) der 3D-Ionenfalle (für Quantencomputeranwendungen) bilden.

21. Verfahren (300) nach einem der Ansprüche 17 bis 20, ferner mit folgenden Schritten:
Anordnen einer Interconnect-Struktur (264-1) an dem rückgedünnten Basis-Substrat (202-1) und einer weiteren Interconnect-Struktur (264-2) an dem weiteren Substrat (200-2); und
Verbinden des rückgedünnten Basis-Substrats (202-1) und des weiteren Substrats (200-2) durch Verbinden der gegenüberliegenden Interconnect-Strukturen (264-1, 264-2), wobei die verbundenen Interconnect-Strukturen (264-1, 264-2) die Abstandshalterstruktur bilden.

22. Verfahren (300) nach einem der Ansprüche 17 bis 21, wobei bei dem Schritt des Verbindens des rückgedünnten Basis-Substrats (202-1) und des weiteren Substrats (200-2) die Abstandshalterstruktur (260) als ein Abstandssubstrat ausgebildet ist und zwischen dem rückgedünnten Basis-Substrat (202-1) und dem weiteren Substrat (200-2) angeordnet wird.

23. Verfahren (300) nach einem der Ansprüche 17 bis 22, wobei die Abstandshalterstruktur (260) ein dielektrisches Material, wie z.B. Glas, Diamant, Saphir, Korund oder Keramik, aufweist.

24. Verfahren (300) nach einem der Ansprüche 17 bis 23, wobei das Basis-Substrat (202-1) während der Schritte des Verbindens mit dem Isolationssubstrat (250-1, 250-2), des Rückdünnens des Basis-Substrats (202-1) und des Verbindens mit dem weiteren Substrat (200-2) auf einem Trägersubstrat, z.B. aus einem dielektrisches Material, wie Glas, Diamant, Saphir, Korund oder Keramik, fixiert wird.

25. Verfahren (300) nach einem der Ansprüche 17 bis 24, ferner mit folgendem Schritt:
Strukturieren der Elektrodenstruktur (206) des rückgedünnten Basis-Substrats (202-1) und/oder des weiteren Substrats (200-2), z.B. mittels Grautonlithographie, um eine dreidimensional strukturierte Elektrodenstruktur (206) der Elektrodenanordnung (208) zu erhalten.

26. Verfahren (300) nach einem der Ansprüche 17 bis 25, wobei bei dem Schritt des Verbindens des rückgedünnten Basis-Substrats (202-1) und des gegenüberliegenden, weiteren Substrats (200-2) zwischen benachbarten Abstandshalterstrukturen (260) ein Freiraum (282) gebildet wird, ferner mit folgendem Schritt:
Anordnen einer Metallisierungsfläche (284) bereichsweise oder vollständig an nicht-metallischen Seitenwandbereichen (286) des Freiraums (282).

27. Verfahren nach einem der Ansprüche 17 bis 26, ferner umfassend ein Bereitstellen einer Metallverbindung (270), die zumindest einen Teil der weiteren Elektrodenstruktur (206-2) des weiteren Substrats elektrisch verbindet mit zumindest einem Teil der Elektrodenstruktur (206-1) des rückgedünnten Basis-Substrats (202-1).

## Claims

1. Method (100) for manufacturing an electrode structure (206) for an ion trap, comprising:
providing (110) a base substrate (202) comprising a patterned metallization arrangement (230) arranged in an insulation material (220) on a semiconductor layer (210),
providing (120) an insulation substrate (250) comprising a dielectric material (252),
connecting (130) a surface region (224) of the base substrate (202) arranged on the insulation material (220) to the insulation substrate (250) by means of a bonding process, and
backthinning (140) the base substrate (202) by removing the semiconductor layer (210) to the insulation material (220) of the base substrate (202),
wherein the electrode structure (206) for the ion trap is formed by performing the step of backthinning to the metallization arrangement (230), or by depositing a patterned surface metallization (240) on the insulation material (220) of the back-thinned base substrate (202),
**or**
wherein the electrode structure (206) for the ion trap is formed by the patterned metallization arrangement (230).

2. Method (100) according to claim 1, wherein the metallization arrangement (230) is configured as a multilayer metallization arrangement, wherein the electrode structure (206) for the ion trap is formed by performing the step of backthinning to an uppermost patterned metallization layer (232a) of the multilayer metallization arrangement.

3. Method (100) according to claim 1 or 2, further comprising:
performing the bonding process between the insulation material (220) of the base substrate (202) and the insulation substrate (250) by means of an oxide/oxide bonding process.

4. Method (100) according to any one of the preceding claims, wherein the surface region (224) of the base substrate (202) arranged on the insulation material (250), and the insulation substrate (250) each have associated metal pads (238a, b, 254), further comprising:
performing the bonding process between the base substrate (202) and the insulation substrate (250) at the associated metal pads (238a, b, 254) by means of a metal bonding process.

5. Method (100) according to any one of the preceding claims, wherein the bonding process is performed as a combination (hybrid bonding process) of an oxide/oxide bonding process and a metal bonding process.

6. Method (100) according to any one of the preceding claims, wherein the exposed metallization layer (232a) of the metallization arrangement (230) **or** the deposited patterned surface metallization (240) on the insulation material (220) of the back-thinned base substrate (202) forms the electrode structure (206) for the surface ion trap.

7. Method (100) according to any one of the preceding claims, further comprising:
forming a recess (228) in the form of a hole or trench in the base substrate (202) through the insulation material (220) of the metallization arrangement to the semiconductor layer (210).

8. Method (100) according to claim 7, wherein the step of forming a recess (228) is performed by means of hole or trench etching.

9. Method (100) according to claim 7 or 8, further comprising:
arranging a metallization (246) partially or completely on side walls (248) of the recess (228) in the insulation material (220) of the back-thinned base substrate (202).

10. Method (100) according to any one of the preceding claims, wherein the semiconductor layer (210) of the base substrate (202) is completely removed in the step of backthinning the base substrate (202).

11. Method (100) according to any one of the preceding claims, wherein the metallization arrangement (230) embedded in the insulation material (220) is configured as an antenna structure for providing electric fields for the ion trap.

12. Method (100) according to any one of the preceding claims, wherein the base substrate (202) is configured as a standard substrate from semiconductor manufacturing or as an IC substrate.

13. Method (100) according to any one of the preceding claims, wherein the dielectric material of the insulation substrate (250) comprises glass, diamond, sapphire, corundum or ceramic.

14. Method (100) according to any one of the preceding claims, wherein the insulation material (220) of the base substrate (202) comprises a dielectric from semiconductor manufacturing, such as SiO₂ or HfO₂.

15. Method (100) according to any one of the preceding claims, wherein the method for manufacturing an electrode structure (206) for an ion trap is performed by means of standard semiconductor manufacturing process steps.

16. Method (100) according to any one of the preceding claims, wherein the ion trap is provided for quantum computing applications.

17. Method (300) for manufacturing an electrode arrangement (208) for a 3-dimensional ion trap, comprising:
performing the method (100) according to any one of the preceding claims to manufacture an electrode structure (206-1) on a back-thinned base substrate (202-1),
providing a further substrate (200-2) with a further electrode structure (206-2),
connecting the back-thinned base substrate (202-1) and the further substrate (200-2) by means of a spacer structure (260) arranged therebetween, so that the electrode structure (206-1) and the further electrode structure (206-2) face each other and form the electrode arrangement (208) for the 3-dimensional ion trap.

18. Method (300) according to claim 17, wherein providing the further substrate (200-2) includes performing the method (100) according to any one of claims 1 to 16 to manufacture a further back-thinned base substrate (202-2) with an electrode structure forming the further electrode structure (206-2), wherein connecting the back-thinned base substrate (202-1) and the further substrate (200-2) is performed on the further back-thinned base substrate (202-2).

19. Method (300) according to claim 17 or 18, wherein in the step of connecting the back-thinned base substrate (202-1) and the further substrate (200-2), two laterally adjacent electrode structures (206-1) of the back-thinned base substrate (202-1) are arranged vertically opposite to two laterally adjacent electrode structures (206-2) of the further substrate (200-2).

20. Method (300) according to claim 19, wherein the two vertically opposite pairs of the electrode structures (206-1, 206-2) form the controllable electrode arrangement (208) of the 3D ion trap (for quantum computing applications).

21. Method (300) according to any one of claims 17 to 20, further comprising:
arranging an interconnect structure (264-1) on the back-thinned base substrate (202-1) and a further interconnect structure (264-2) on the further substrate (200-2); and
connecting the back-thinned base substrate (202-1) and the further substrate (200-2) by connecting the opposing interconnect structures (264-1, 264-2), wherein the connected interconnect structures (264-1, 264-2) form the spacer structure.

22. Method (300) according to any one of claims 17 to 21, wherein in the step of connecting the back-thinned base substrate (202-1) and the further substrate (200-2), the spacer structure (260) is configured as a spacer substrate and is arranged between the back-thinned base substrate (202-1) and the further substrate (200-2).

23. Method (300) according to any one of claims 17 to 22, wherein the spacer structure (260) comprises a dielectric material, such as glass, diamond, sapphire, corundum or ceramic.

24. Method (300) according to any one of claims 17 to 23, wherein the base substrate (202-1) is fixed on a carrier substrate, e.g., made of a dielectric material such as glass, diamond, sapphire, corundum or ceramic, during the steps of connecting to the insulation substrate (250-1, 250-2), backthinning the base substrate (202-1) and connecting to the further substrate (200-2).

25. Method (300) according to any one of claims 17 to 24, further comprising:
patterning the electrode structure (206) of the back-thinned base substrate (202-1) and/or of the further substrate (200-2), for example by means of grey tone lithography, in order to acquire a three-dimensionally patterned electrode structure (206) of the electrode arrangement (208).

26. Method (300) according to any one of claims 17 to 25, wherein in the step of connecting the back-thinned base substrate (202-1) and the opposing further substrate (200-2), a free space (282) is formed between adjacent spacer structures (260), further comprising:
arranging a metallization surface (284) partially or completely on non-metallic side wall regions (286) of the free space (282).

27. Method according to any one of claims 17 to 26, further comprising providing a metal connection (270) electrically connecting at least a part of the further electrode structure (206-2) of the further substrate to at least a part of the electrode structure (206-1) of the back-thinned base substrate (202-1).

## Revendications

1. Procédé (100) destiné à fabriquer une structure d'électrode (206) pour un piège à ions, comprenant les étapes suivantes :
fournir (110) un substrat de base (202) qui présente sur une couche semiconductrice (210) un ensemble de métallisation structuré (230) disposé dans un matériau isolant (220),
fournir (120) un substrat isolant (250) qui présente un matériau diélectrique (252),
connecter (130) une région de surface (224) du substrat de base (202), qui est disposée sur le matériau isolant (220), avec le substrat isolant (250) à l'aide d'un processus de liaison, et
amincir (140) le substrat de base (202) en retirant la couche semiconductrice (210) jusqu'au matériau isolant (220) du substrat de base (202),
dans lequel la structure d'électrode (206) pour le piège à ions est formée en réalisant l'étape d'amincissement jusqu'à l'ensemble de métallisation (230) ou en appliquant une métallisation de surface structurée (240) sur le matériau isolant (220) du substrat de base aminci (202),
**ou**
dans lequel la structure d'électrode (206) pour le piège à ions est formée par l'ensemble de métallisation structuré (230).

2. Procédé (100) selon la revendication 1, dans lequel l'ensemble de métallisation (230) est conçu sous la forme d'un ensemble de métallisation multicouche, dans lequel la structure d'électrode (206) pour le piège à ions est formée en réalisant l'étape d'amincissement jusqu'à une couche de métallisation structurée supérieure (232a) de l'ensemble de métallisation multicouche.

3. Procédé (100) selon la revendication 1 ou 2, comprenant en outre l'étape suivante :
réaliser le processus de liaison entre le matériau isolant (220) du substrat de base (202) et le substrat isolant (250) à l'aide d'un processus de liaison oxyde/oxyde.

4. Procédé (100) selon l'une des revendications précédentes, dans lequel la région de surface (224) du substrat de base (202), qui est disposée sur le matériau isolant (250), et le substrat isolant (250) présentent respectivement des surfaces de connexions métalliques associées (238a, b, 254), comprenant en outre l'étape suivante :
réaliser le processus de liaison entre le substrat de base (202) et le substrat isolant (250) au niveau des surfaces de connexions métalliques associées (238a, b, 254) à l'aide d'un processus de liaison métallique.

5. Procédé (100) selon l'une des revendications précédentes, dans lequel le processus de liaison est réalisé sous la forme d'une combinaison (processus de liaison hybride) d'un processus de liaison oxyde/oxyde et d'un processus de liaison métallique.

6. Procédé (100) selon l'une des revendications précédentes, dans lequel la couche de métallisation exposée (232a) de l'ensemble de métallisation (230) **ou** la métallisation de surface structurée appliquée (240) sur le matériau isolant (220) du substrat de base aminci (202) forme la structure d'électrode (206) pour le piège à ions de surface.

7. Procédé (100) selon l'une des revendications précédentes, comprenant en outre l'étape suivante :
former un évidement (228) sous la forme d'un trou ou d'une tranchée dans le substrat de base (202) à travers le matériau isolant (220) de l'ensemble de métallisation jusqu'à la couche semi-conductrice (210).

8. Procédé (100) selon la revendication 7, dans lequel l'étape de formation d'un évidement (228) est réalisée à l'aide d'une gravure de trou ou de tranchée.

9. Procédé (100) selon la revendication 7 ou 8, comprenant en outre l'étape suivante :
disposer une métallisation (246) dans certaines régions ou la totalité des parois latérales (248) de l'évidement (228) dans le matériau isolant (220) du substrat de base aminci (202).

10. Procédé (100) selon l'une des revendications précédentes, dans lequel lors de l'étape d'amincissement du substrat de base (202) la couche semi-conductrice (210) du substrat de base (202) est totalement retirée.

11. Procédé (100) selon l'une des revendications précédentes, dans lequel l'ensemble de métallisation (230) intégré dans le matériau isolant (220) est conçu sous la forme d'une structure d'antenne pour fournir des champs électriques pour le piège à ions.

12. Procédé (100) selon l'une des revendications précédentes, dans lequel le substrat de base (202) est conçu sous la forme d'un substrat standard provenant de la fabrication de semi-conducteurs ou la forme d'un substrat de circuit intégré.

13. Procédé (100) selon l'une des revendications précédentes, dans lequel le matériau diélectrique du substrat isolant (250) présente du verre, du diamant, du saphir, du corindon ou de la céramique.

14. Procédé (100) selon l'une des revendications précédentes, dans lequel le matériau isolant (220) du substrat de base (202) présente un diélectrique provenant de la fabrication de semi-conducteurs, tel que par exemple SiO₂ ou HfO₂.

15. Procédé (100) selon l'une des revendications précédentes, dans lequel le procédé de fabrication d'une structure d'électrode (206) pour un piège à ions est réalisé à l'aide d'étapes de processus de fabrication de semi-conducteurs standards.

16. Procédé (100) selon l'une des revendications précédentes, dans lequel le piège à ions est prévu pour des applications d'ordinateur quantique.

17. Procédé (300) destiné à fabriquer un ensemble électrode (208) pour un piège à ions tridimensionnel, comprenant les étapes suivantes :
réaliser le procédé (100) selon l'une des revendications précédentes, pour fabriquer une structure d'électrode (206-1) sur un substrat de base aminci (202-1),
fournir un autre substrat (200-2) avec une autre structure d'électrode (206-2),
connecter le substrat de base aminci (202-1) et l'autre substrat (200-2) à l'aide d'une structure d'espacement (260) disposée entre ceux-ci de telle sorte que la structure d'électrode (206-1) et l'autre structure d'électrode (206-2) se trouvent en face l'une de l'autre et forment l'ensemble électrode (208) pour le piège à ions tridimensionnel.

18. Procédé (300) selon la revendication 17, dans lequel la fourniture de l'autre substrat (200-2) comprend une réalisation du procédé (100) selon l'une des revendications 1 à 16 pour fabriquer un autre substrat de base aminci (202-2) avec une structure d'électrode qui forme l'autre structure d'électrode (206-2), dans lequel la connexion du substrat de base aminci (202-1) et de l'autre substrat (200-2) se fait au niveau de l'autre substrat de base aminci (202-2).

19. Procédé (300) selon la revendication 17 ou 18, dans lequel dans l'étape de connexion du substrat de base aminci (202-1) et de l'autre substrat (200-2) deux structures d'électrode latérales adjacentes (206-1) du substrat de base aminci (202-1) sont disposées verticalement de manière opposée à deux structures d'électrode latérales adjacentes (206-2) de l'autre substrat (200-2).

20. Procédé (300) selon la revendication 19, dans lequel les deux paires de structures d'électrode (206-1, 206-2) opposées verticalement forment l'ensemble électrode commandable (208) du piège à ions 3D (pour les applications d'ordinateur quantique).

21. Procédé (300) selon l'une des revendications 17 à 20, comprenant en outre les étapes suivantes :
disposer une structure d'interconnexion (264-1) sur le substrat de base aminci (202-1) et une autre structure d'interconnexion (264-2) sur l'autre substrat (200-2) ; et
connecter le substrat de base aminci (202-1) et l'autre substrat (200-2) en connectant les structures d'interconnexion opposées (264-1, 264-2), les structures d'interconnexion connectées (264-1, 264-2) formant la structure d'espacement.

22. Procédé (300) selon l'une des revendications 17 à 21, dans lequel dans l'étape de connexion du substrat de base aminci (202-1) et de l'autre substrat (200-2) la structure d'espacement (260) est conçue sous la forme d'un substrat d'espacement et est disposée entre le substrat de base aminci (202-1) et l'autre substrat (200-2).

23. Procédé (300) selon l'une des revendications 17 à 22, dans lequel la structure d'espacement (260) présente un matériau diélectrique, tel que par exemple du verre, du diamant, du saphir, du corindon ou de la céramique.

24. Procédé (300) selon l'une des revendications 17 à 23, dans lequel le substrat de base (202-1) est fixé, pendant les étapes de connexion avec le substrat isolant (250-1, 250-2), d'amincissement du substrat de base (202-1) et de connexion avec l'autre substrat (200-2), sur un substrat porteur, par exemple à partir d'un matériau diélectrique, tel que le verre, le diamant, le saphir, le corindon ou la céramique.

25. Procédé (300) selon l'une des revendications 17 à 24, comprenant en outre l'étape suivante :
structurer la structure d'électrode (206) du substrat de base aminci (202-1) et/ou de l'autre substrat (200-2), par exemple à l'aide d'une lithographie en niveaux de gris, pour obtenir une structure d'électrode structurée en trois dimensions (206) de l'ensemble électrode (208).

26. Procédé (300) selon l'une des revendications 17 à 25, dans lequel dans l'étape de connexion du substrat de base aminci (202-1) et de l'autre substrat opposé (200-2) entre des structures d'espacement adjacentes (260) est formé un espace libre (282), comprenant en outre l'étape suivante :
disposer une surface de métallisation (284) dans certaines régions ou la totalité des régions de parois latérales non métalliques (286) de l'espace libre (282).

27. Procédé selon l'une des revendications 17 à 26, comprenant en outre une fourniture d'une connexion métallique (270), qui connecte électriquement au moins une partie de l'autre structure d'électrode (206-2) de l'autre substrat avec au moins une partie de la structure d'électrode (206-1) du substrat de base aminci (202-1).
